# EUROPÄISCHE PATENTSCHRIFT

(11) **EP 1 957 505 B1**
(45) Veröffentlichungstag und Bekanntmachung des Hinweises auf die Patenterteilung: **29.12.2010**
(21) Anmeldenummer: 06828977.6
(22) Anmeldetag: 09.11.2006
(51) Int. Cl.: C07F 15/00

(54) **VERFAHREN ZUR HERSTELLUNG ORTHO-METALLIERTER METALLVERBINDUNGEN**
PROCESS FOR PREPARING ORTHO-METALLATED METAL COMPOUNDS
PROCEDE DE FABRICATION DE COMPOSES METALLIQUES ORTHO-METALLISES

(30) Priorität: 05.12.2005 DE 102005057963
(43) Veröffentlichungstag der Anmeldung: 20.08.2008
(73) Patentinhaber: Merck Patent GmbH, 64293 Darmstadt (DE)
(72) Erfinder: STOESSEL, Philipp, 60487 Frankfurt/Main (DE); FORTTE, Rocco, 65933 Frankfurt (DE); PARHAM, Amir, 65929 Frankfurt (DE); BREUNING, Esther, 65527 Niedernhausen (DE); HEIL, Holger, 64295 Darmstadt (DE); VESTWEBER, Horst, 34630 Gilersberg-Winterscheid (DE)
(86) Internationale Anmeldenummer: PCT/EP2006/010740
(87) Internationale Veröffentlichungsnummer: WO 2007/065523

(56) Entgegenhaltungen:
- WO-A-2004/085449
- WO-A2-2004/084326
- KING, K.A. ET AL.: "Excited-state properties of a triply otho-metalated Iridium (III) complex" JOURNAL OF THE AMERICAN CHEMICAL SOCIETY, Bd. 107, 1985, Seiten 1431-1432, XP002415308 in der Anmeldung erwähnt

## Beschreibung

Die vorliegende Erfindung beschreibt ein Verfahren zur Herstellung homoleptischer und heteroleptischer tris-ortho-metallierter Metallverbindungen aus einfachen Ausgangsverbindungen.

Metallorganische Verbindungen, speziell Verbindungen der d⁸-Metalle, finden Einsatz als funktionelle Materialien in einer Reihe verschiedenartiger Anwendungen, die im weitesten Sinne der Elektronikindustrie zugerechnet werden können. Der allgemeine Aufbau organischer Elektrolumineszenzvorrichtungen bzw. deren Einzelbauteilen, den organischen lichtemittierenden Dioden (OLEDs), ist in US 4539507 und US 5151629 beschrieben. Eine Entwicklung hierzu ist der Einsatz metallorganischer Komplexe, die Phosphoreszenz statt Fluoreszenz zeigen (M. A. Baldo et al., Appl. Phys. Lett. 1999, 75, 4-6). Aus Spin-statistischen Gründen ist unter Verwendung metallorganischer Verbindungen eine bis zu vierfache Energie- und Leistungseffizienz möglich. Diese Entwicklung scheint sich, zumindest für rote und grüne Emission, gegenüber Singulett-Emittern durchzusetzen.

Hierfür muss der effiziente chemisch-synthetische Zugang zu den entsprechenden, hochreinen Organometall-Verbindungen gegeben sein. Dies ist insbesondere unter Berücksichtigung der Seltenheit der späten Übergangsmetalle Rh, Ir, Pd und Pt von maßgebender Bedeutung für die ressourcenschonende Nutzung der genannten Verbindungsklasse.

Auch für die Verwendung entsprechender Metallkomplexe als Monomere für die Herstellung von Oligomeren und Polymeren ist ein effizienter Zugang zu entsprechend funktionalisierten Metallkomplexen nötig. Dies erfordert insbesondere einen geeigneten Zugang zu heteroleptischen Metallkomplexen, welche an einem oder zwei der Liganden polymerisierbare Gruppen tragen, während der dritte Ligand nicht durch polymerisierbare Gruppen funktionalisiert ist.

In der Literatur sind einige Verfahren zur Darstellung tris-ortho-metallierter Organoiridiumverbindungen beschrieben. Die Synthesewege, die Ausbeuten und die charakteristischen Eigenschaften der Synthesen sind im Folgenden kurz am Grundkörper der genannten Verbindungsklasse, dem Tris[2-(2-pyridinyl-κN)phenyl-κC]-iridium(III), dargelegt.

Ausgehend von hydratisiertem Iridium(III)-chlorid und 2-Phenylpyridin in einer Mischung aus Ethoxyethanol / Wasser (3 : 1) wurde *fac*-Tris-[2-(2-pyridinyl-κN)phenyl-κC]-iridium(III) nach aufwändigen chromatographischen Reinigungsverfahren als Nebenprodukt in etwa 10 %iger Ausbeute erhalten, während als Hauptprodukt der dimere chloro-verbrückte Iridiumkomplex anfällt (K. A. King, P. J. Spellane, R. J. Watts, J. Am. Chem. Soc. 1985, 107, 1431-1432).

K. Dedeian *et al.* beschreiben ein Verfahren ausgehend von Iridium(III)-tris(acetylacetonat) und 2-Phenylpyridin, nach dem *fac*-Tris[2-(2-pyridinyl-κN)phenyl-κC]-iridium(III) in 45 %iger Ausbeute erhalten wurde. Auch bei diesem Verfahren muss das Produkt durch chromatographische Verfahren von Verunreinigungen gereinigt werden, wobei hier halogenierte Kohlenwasserstoffe zum Einsatz kommen (K. Dedeian, P. I. Djurovich, F. O. Garces, G. Carlson, R. J. Watts, Inorg. Chem. 1991, 30, 1685-1687).

In einem weiteren Verfahren wird Di-µ-chlorotetrakis[2-(2-pyridinyl-κN)phenyl-κC]di-iridium(III), welches zunächst in ca. 72 %iger Ausbeute aus hydratisiertem Iridium(III)-chlorid und 2-Phenylpyridin dargestellt wird (S. Spouse, K. A. King, P. J. Spellane, R. J. Watts, J. Am. Chem. Soc. 1984, 106, 6647-6653), als Edukt verwendet. Dieses wird mit 2-Phenylpyridin und der zweifach molaren Menge an Silbertrifluormethylsulfonat, bezogen auf das Di-µ-chlorotetrakis[2-(2-pyridinyl-κN)phenyl-κC]di-iridium(IIl), umgesetzt. Nach chromatographischer Reinigung erhalten die Autoren *fac*-Tris[2-(2-pyridinyl-κN)phenyl-κC]-iridium(III) in 75 %iger Ausbeute (M. G. Colombo, T. C. Brunold, T. Riedener, H. U. Güdel, Inorg. Chem. 1994, 33, 545-550). Neben der chromatographischen Aufreinigung, die wiederum mit halogenierten Kohlenwasserstoffen erfolgt, ist die Verwendung von Silbertrifluormethylsulfonat nachteilig, weil Silberspuren kaum aus dem Produkt entfernt werden können und sich negativ auf die optoelektronischen Eigenschaften der Iridiumkomplexe auswirken.

Die Synthese von facialem und meridionalem Tris[2-(2-pyridinyl-κN)phenyl-κC]-iridium(III) wurde von M. Thompson *et al.* (A. B. Tamayo, B. D. Alleyne, P. I. Djurovich, S. Lamansky, I. Tsyba, N. N. Ho, M. E. Thompson, J. Am. Chem. Soc. 2003, 125, 7377-7387) beschrieben. Dazu wird Di-µ-chlorotetrakis[2-(2-pyridinyl-κN)phenyl-κC]di-iridium(III) mit Phenylpyridin in Glycerin unter Zusatz von Kaliumcarbonat erhitzt. Eine Reaktionstemperatur von ca. 200 °C ergibt dabei den facialen Iridiumkomplex, während eine Reaktionstemperatur von 140-145 °C den meridionalen Iridiumkomplex ergibt. Die Ausbeute liegt in beiden Fällen zwischen 65 und 80 %. In beiden Fällen entstehen Produktgemische, aus denen die reinen Komplexe durch Chromatographie isoliert werden müssen, so dass dieses Verfahren nicht technisch sinnvoll anzuwenden ist.

Das in WO 02/060910 beschriebene Verfahren besteht in der Umsetzung von Iridium(III)-tris(acetylacetonat) und ähnlichen 1,3-Ketoketonat-Komplexen mit einer Arylpyridin- oder Heteroarylpyridinverbindung in Gegenwart eines dipolar protischen Lösemittels unter starkem Erhitzen bei längeren Reaktionszeiten (> 20 h). Hier erhält man sehr gute Ausbeuten (bis zu 96 %) und ebenfalls sehr gute Reinheiten (>99.9 %). Nachteilig ist jedoch, dass bei dieser Synthese von Iridium(III)-tris(acetylacetonat) ausgegangen werden muss, welches erst in einem separaten Syntheseschritt aus Iridiumchlorid hergestellt werden muss. Dabei liegen die in der Literatur zitierten Ausbeuten zur Herstellung von Iridium(III)-tris(acetylacetonat) in der Größenordnung von nur 25 %, so dass hier insgesamt ein erheblicher Verlust an Iridium auftritt. Dasselbe trifft zu für das Verfahren gemäß WO 04/085449, welches von heteroleptischen Iridium-Komplexen, welche zwei Liganden vom Typ Acetylacetonat und zwei weitere Liganden vom Typ Halogenid tragen. Auch hier erhält man die ortho-metallierten Metallkomplexe in hoher Ausbeute und Reinheit, jedoch müssen die Iridium-Ausgangskomplexe in einem separaten Schritt synthetisiert werden, was wiederum zu Ausbeuteverlusten führt. Weiterhin eignen sich beide Verfahren nicht zur Herstellung heteroleptischer Metallkomplexe.

In WO 04/099223 wird ein Verfahren zur Herstellung tris-ortho-metallierter Iridiumkomplexe durch Umsetzung des Liganden mit Iridiumhalogenid in Anwesenheit eines Silber-, Quecksilber-, Aluminium- oder Antimonsalzes beschrieben. Wie oben bereits beschrieben, ist die Verwendung von Metallsalzen, insbesondere Silbersalzen, nachteilig, weil Metallspuren kaum aus dem Produkt entfernt werden können und sich negativ auf die optoelektronischen Eigenschaften der Iridiumkomplexe auswirken. Gleiches gilt auch für die Verwendung von Quecksilber, Antimon und anderen Metallen. Die Verwendung von Quecksilbersalzen bringt weiterhin ein erhebliches Gesundheits- und Umweltrisiko mit sich.

In WO 04/084326 wird ein Verfahren zur Herstellung tris-ortho-metallierter Iridiumkomplexe durch Umsetzung von [L₂IrHal]₂ mit einem weiteren Liganden vom Typ Arylpyridin in Gegenwart eines Hilfsliganden, welcher befähigt ist, die Metall-Halogen-Bindung aufzubrechen, beschrieben. Als Hilfsliganden werden vor allem Pyridine, Triarylphosphine und Ketoketonate beschrieben. Die Synthese kann auch in zwei Stufen in einem Eintopfverfahren aus dem Metallhalogenid durchgeführt werden. Als Lösemittel werden protische Lösemittel, insbesondere Ethylenglycol, verwendet, und die Reaktion wird unter Rückfluss (in Ethylenglycol also bei ca. 197 °C) durchgeführt. Über zwei Stufen, ausgehend von IrCl₃, werden 60 % Ausbeute erhalten. Hier wäre noch eine Verbesserung der Ausbeute wünschenswert. Weiterhin hat dieses Verfahren den Nachteil, dass es unter drastischen Bedingungen (3 Tage Rückfluss bei 197 °C) durchgeführt wird. Dies kann bei empfindlichen Liganden bereits zur Zersetzung des Liganden oder des gebildeten Komplexes führen. Weiterhin sind die Reaktionsbedingungen ungeeignet zur Synthese tris-ortho-metallierter heteroleptischer Metallkomplexe, da unter diesen Reaktionsbedingungen immer ein Ligandenaustausch stattfindet, so dass keine einheitlichen heteroleptischen tris-ortho-metallierten Komplexe isoliert werden können, sondern nur Komplexgemische.

In WO 05/042548 wird ein Verfahren zur Synthese heteroleptischer Iridiumkomplexe durch Umsetzung von [L₂IrHal]₂ mit einem metallorganischen Derivat, insbesondere einem Alkali- oder Erdalkaliderivat, eines Arylpyridinliganden beschrieben. Dabei werden gute Ausbeuten von über 95 % erhalten (ausgehend von. [L₂IrHal]₂). Jedoch hat dieses Verfahren den Nachteil, dass es als Zwischenstufe über ein Alkali- oder Erdalkaliderivat läuft, welches luft- und wasserempfindlich ist, so dass die Reaktion unter besonderen Vorsichtsmaßnahmen durchgeführt werden muss, was insbesondere im technischen Maßstab ein Sicherheitsrisiko bedeuten kann. Diese Methode stellt für die Herstellung homoleptischer Komplexe keinen Vorteil dar, da die Reaktion über zwei Stufen geführt wird und da die Zwischenstufe, [L₂IrHal]₂, in einem separaten Schritt hergestellt, isoliert und gereinigt werden muss. Ein weiterer Nachteil ist, dass die Ligandenvorstufen, die für dieses Verfahren benötigt werden, oftmals nur aufwändig darzustellen oder synthetisch kaum zugänglich sind und dass sich das entsprechende metallorganische Derivat des Liganden in einigen Fällen nicht selektiv bildet.

In JP 2004/238379 wird ein Verfahren zur Synthese von Iridiumkomplexen durch Umsetzung von [L₂IrHal]₂ mit einem weiteren Liganden in Anwesenheit einer Base beschrieben. Als Base wird bevorzugt eine anorganische Base, ein Alkalimetallalkoxid oder ein organisches Amin verwendet. Als Lösemittel werden polare Lösemittel, insbesondere Ethylenglycol, Glycerin, 2-Methoxyethanol, 2-Ethoxyethanol und DMF angegeben. Das einzige Ausführungsbeispiel beschreibt die Synthese unter Verwendung von Triethanolamin als Base in Ethylenglycol unter Einsatz von Mikrowellenstrahlung.

Wie aus der oben aufgeführten Literatur ersichtlich, wäre es von Vorteil, ein breit anwendbares Verfahren zur Verfügung zu haben, durch welches sich tris-ortho-metallierte Iridiumkomplexe einfach, in hoher Ausbeute und unter milden Reaktionsbedingungen aus einfach zugänglichem Iridium(III)-halogenid synthetisieren lassen. Insbesondere für die Synthese heteroleptischer Metallkomplexe sind noch deutliche Verbesserungen gegenüber dem Stand der Technik nötig. Weiterhin wäre es von Vorteil, ein einfaches und reproduzierbares Verfahren zur Herstellung meridionaler Komplexe zur Verfügung zu haben. Diese Komplexe sind mit den Verfahren gemäß dem Stand der Technik nur schwer zugänglich, da sie gegenüber den entsprechenden facialen Komplexen thermodynamisch instabil sind.

Es wurde überraschend gefunden, dass die Synthese tris-ortho-metallierter Rhodium- und Iridiumkomplexe und bis-ortho-metallierter Palladium- und Platinkomplexe ausgehend von Metallhalogeniden oder halogenidverbrückten dimeren Komplexen unter besonders milden Bedingungen abläuft und besonders gute Ausbeuten ergibt, wenn die Reaktion in Anwesenheit eines Salzes, dessen Anion mindestens zwei Sauerstoffatome enthält, in einem Lösemittelgemisch aus einem organischen Lösemittel und mindestens 5 Vol.% Wasser durchgeführt wird. Durch dieses Verfahren lassen sich, je nach Wahl des zugesetzten Salzes, selektiv sowohl die facialen wie auch die sonst nur schwer zugänglichen meridionalen Iridium-Komplexe erhalten. Die meridionalen können in einem Folgeschritt auch in die entsprechenden facialen Komplexe umgewandelt werden. Damit handelt es sich um das erste Verfahren, welches aus einfach zugänglichem hydratisiertem Iridiumhalogenid in einem Schritt unter milden Reaktionsbedingungen und in guten Ausbeuten zu tris-ortho-metallierten Iridiumkomplexen führt. Dieses Ergebnis ist insbesondere deshalb überraschend, da aus der Literatur bekannt ist, dass einerseits die Verwendung einer Mischung aus Ethoxyethanol und Wasser nur zu Ausbeuten in der Größenordnung von 10 % führt und da andererseits die Verwendung eines rein organischen Lösemittels zusammen mit einer Base drastische Reaktionsbedingungen (Aktivierung durch Einsatz von Mikrowellenstrahlung) erfordert, um hohe Ausbeuten zu erzielen. Es ist daher nicht naheliegend, dass die Kombination eines Lösemittelsystems aus einem organischen Lösemittel und Wasser zusammen mit bestimmten Salzen einen solch starken Einfluss auf den Reaktionsverlauf hat. Weiterhin hat sich gezeigt, dass das Verfahren nicht nur für die Synthese von Iridiumkomplexen, sondern auch für die Synthese entsprechender Rhodium-, Palladium- und Platinkomplexe anwendbar ist.

Gegenstand der Erfindung ist ein Verfahren zur Herstellung von Metallkomplexen der Formel (1), 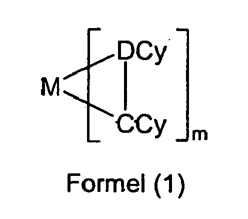 worin gilt:
- M: ist Rh, Ir, Pd oder Pt;
- DCy: ist bei jedem Auftreten gleich oder verschieden eine cyclische Gruppe, die mindestens ein neutrales Donoratom, bevorzugt Stickstoff oder Phosphor, enthält, über welches die cyclische Gruppe an das Metall gebunden ist, und die einen oder mehrere Substituenten R tragen kann; die Gruppen DCy und CCy sind über eine kovalente Bindung miteinander verbunden; außerdem können sie weiterhin über einen Rest R miteinander verbunden sein;
- CCy: ist bei jedem Auftreten gleich oder verschieden eine cyclische Gruppe, die ein Kohlenstoffatom oder ein negativ geladenes Stickstoffatom enthält, über welches die cyclische Gruppe an das Metall gebunden ist, und die einen oder mehrere Substituenten R tragen kann;
- R: ist bei jedem Auftreten gleich oder verschieden F, Cl, Br, I, NO₂, CN, NH₂, NHR¹, N(R¹)₂, B(OH)₂, B(OR¹)₂, CHO, COOH, CON(R¹)₂, SO₃H, C(=O)R¹, P(=O)(R¹)₂, S(=O)R¹, S(=O)₂R¹, P(R¹)₃⁺, N(R¹)₃⁺, OH, SH, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, wobei jeweils ein oder mehrere nicht benachbarte CH₂-Gruppen durch -O-, -S-, -NR¹-, -CONR¹-, -CO-O-, -CR¹=CR¹- oder -C≡C- ersetzt sein können und die auch durch eine oder mehrere Gruppen R² substituiert sein kann, oder ein aromatisches oder heteroaromatisches Ringsystem mit 5 bis 30 aromatischen Ringatomen, das durch einen oder mehrere Reste R² substituiert sein kann, oder eine Aryloxy-, Heteroaryloxy-, Arylamino- oder Heteroarylaminogruppe mit 5 bis 30 aromatischen Ringatomen, die durch einen oder mehrere Reste R² substituiert sein kann; dabei können zwei oder mehrere Substituenten R, sowohl am selben Ring als auch an den beiden unterschiedlichen Ringen zusammen, wiederum miteinander oder mit R¹, R² und/oder R³ ein weiteres mono- oder polycyclisches, aliphatisches oder aromatisches Ringsystem aufspannen;
- R¹: ist bei jedem Auftreten gleich oder verschieden H, eine geradkettige Alkylgruppe mit 1 bis 20 C-Atomen oder eine verzweigte oder cyclische Alkylgruppe mit 3 bis 20 C-Atomen, wobei jeweils ein oder mehrere nicht benachbarte CH₂- Gruppen, die nicht direkt an ein Heteroatom binden, durch -O-, -S-, -NR³-, -CONR³-, -CO-O-, -CR³=CR³- oder -C≡C- ersetzt sein können und die auch durch eine oder mehrere Gruppen R² substituiert sein kann, oder ein aromatisches oder heteroaromatisches Ringsystem mit 5 bis 30 aromatischen Ringatomen, das durch einen oder mehrere Reste R² substituiert sein kann; dabei können zwei oder mehrere Substituenten R¹ wiederum miteinander oder mit R, R² und/oder R³ ein weiteres mono- oder poly- cyclisches, aliphatisches oder aromatisches Ringsystem aufspannen;
- R²: ist bei jedem Auftreten gleich oder verschieden H, F, Cl, Br, I, NO₂, CN, NH₂, NHR³, N(R³)₂, B(OH)₂, B(OR³)₂, CHO, COOH, CON(R³)₂, SO₃H, C(=O)R¹, P(=O)(R¹)₂, S(=O)R¹, S(=O)₂R¹, P(R³)₃⁺, N(R³)₃⁺, OH, SH, eine geradkettige Alkyl- oder Alkoxygruppe mit 1 bis 20 C-Atomen oder eine verzweigte oder cyclische Alkyl- oder Alkoxygruppe mit 3 bis 20 C- Atomen, wobei jeweils ein oder mehrere nicht benachbarte CH₂-Gruppen durch -O-, -S-, -NR³-, -CONR³-, -CO-O-, -CR³=CR³- oder -C≡C- ersetzt sein können und die auch durch eine oder mehrere Gruppen R³ substituiert sein kann, oder ein aromatisches oder heteroaromatisches Ringsystem mit 5 bis 30 aromatischen Ringatomen, das durch einen oder mehrere Reste R³ substituiert sein kann, oder eine Aryloxy-, Heteroaryloxy-, Arylamino- oder Heteroarylaminogruppe mit 5 bis 30 aromatischen Ringatomen, die durch einen oder mehrere Reste R³ substituiert sein kann; dabei können zwei oder mehrere Substituenten R², sowohl am selben Ring als auch an den beiden unterschiedlichen Ringen zusammen, wiederum miteinander oder mit R, R¹ und/oder R³ ein weiteres mono- oder polycyclisches, aliphatisches oder aromatisches Ringsystem aufspannen;
- R³: ist gleich oder verschieden bei jedem Auftreten H oder ein aliphatischer oder aromatischer Kohlenwasserstoffrest mit 1 bis 20 C-Atomen; dabei können auch zwei oder mehrere Reste R³ miteinander ein Ringsystem bilden;
- m: ist 2 für M = Pd oder Pt und ist 3 für M = Rh oder Ir;
durch Umsetzung einer Metallverbindung der Formel (2), der Formel (3) oder der Formel (4) 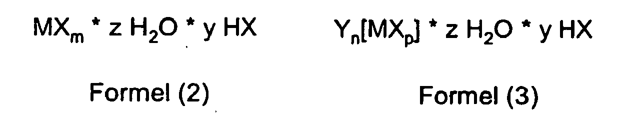 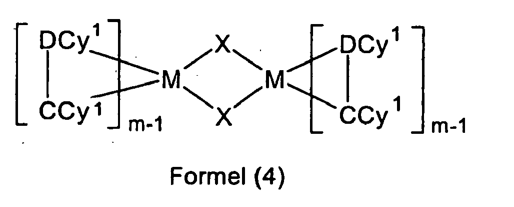 wobei M und m dieselbe Bedeutung haben, wie für Formel (1) beschrieben, und für die weiteren Symbole und Indizes gilt:
- X: ist bei jedem Auftreten gleich oder verschieden F, Cl, Br oder I;
- Y: ist bei jedem Auftreten gleich oder verschieden ein Alkali- metallkation, ein Erdalkalimetallkation, ein Ammoniumkation, ein Tetraalkylammoniumkation mit 4 bis 40 C-Atomen oder ein Tetraalkylphosphoniumkation mit 4 bis 40 C-Atomen;
- p: ist 4 für M = Pd oder Pt und ist 6 für M = Rh oder Ir;
- n: entspricht der Ladung von M für ein einwertiges Kation Y und entspricht der halben Ladung von M für ein zweiwertiges Kation Y;
- z: ist 0 bis 100;
- y: ist 0 bis 100;
mit einer Verbindung der Formel (5), 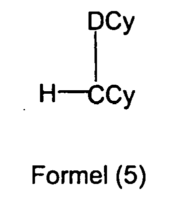 worin DCy und CCy die unter Formel (1) genannten Bedeutungen haben,
**dadurch gekennzeichnet, dass** die Reaktion in Anwesenheit eines Salzes, dessen Anion mindestens zwei Sauerstoffatome enthält, in einem Lösemittelgemisch aus mindestens einem organischen Lösemittel und mindestens 2 Vol.-% Wasser durchgeführt wird.

Dabei bedeutet cyclisch im Sinne dieser Erfindung sowohl monocyclisch, wie auch bicyclisch oder polycyclisch.

Wenn die Reste miteinander ein Ringsystem bilden, so können hieraus kondensierte aromatische oder nicht-aromatische Systeme gebildet werden. Dabei sei nochmals explizit betont, dass auch Reste, die an verschiedenen Gruppen, beispielsweise an CCy und DCy gebunden sind, miteinander ein Ringsystem bilden können.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Adamantyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 1 bis 30 aromatischen Ringatomen, welches noch jeweils mit den oben genannten Resten R² bzw. R³ substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Truxen, Isotruxen, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4 Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Je nach Ausgangsprodukten und Liganden können sowohl homoleptische wie auch heteroleptische Metallkomplexe synthetisiert werden. Unter einem homoleptischen Komplex wird eine Verbindung verstanden, in der nur gleiche Liganden an ein Metall gebunden sind. Heteroleptische Komplexe sind solche, in denen unterschiedliche Liganden an das Metall gebunden sind. Dies bezieht sich sowohl auf Liganden mit unterschiedlicher Ligandengrundstruktur wie auch auf Liganden, die dieselbe Grundstruktur aufweisen, die jedoch unterschiedlich substituiert sind. Wird eine Verbindung gemäß Formel (2) bzw. eine Verbindung gemäß Formel (3) mit einer Verbindung gemäß Formel (5) umgesetzt, entstehen im Allgemeinen homoleptische Metallkomplexe. Wird eine Verbindung gemäß Formel (4) mit einem gleichartigen Liganden gemäß Formel (5) umgesetzt, entstehen ebenfalls im Allgemeinen homoleptische Metallkomplexe. Wird eine Verbindung gemäß Formel (4) mit einem andersartigen Liganden gemäß Formel (5) umgesetzt, entstehen heteroleptische Metallkomplexe. Bevorzugte oktaedrische heteroleptische Metallkomplexe sind solche, die zwei gleiche Liganden und einen dritten unterschiedlichen Liganden enthalten.

Durch das erfindungsgemäße Verfahren sind, je nach Reaktionsführung, selektiv sowohl die facialen wie auch die meridionalen oktaedrischen Komplexe zugänglich.

Faciale bzw. meridionale Koordination im Sinne dieser Anmeldung beschreibt die oktaedrische Umgebung des Metalls M mit den sechs Donoratomen. Eine faciale Koordination liegt vor, wenn drei identische Donoratome eine Dreiecksfläche im (pseudo)oktaedrischen Koordinationspolyeder und drei identische, aber von den ersten verschiedene Donoratome eine andere Dreiecksfläche im (pseudo)oktaedrischen Koordinationspolyeder besetzen. Bei einer merdionalen Koordination besetzen drei identische Donoratome den einen Meridian im (pseudo)-oktaedrischen Koordinationspolyeder und drei identische, aber von den ersten verschiedene Donoratome den anderen Meridian im (pseudo)-oktaedrischen Koordinationspolyeder. Dies ist im Folgenden am Beispiel der Koordination von drei N-Donoratomen und drei C-Donoratomen gezeigt (Schema 1). Da sich diese Definition auf Donoratome bezieht und nicht auf die Cyclen CCy und DCy, die diese Donoratome bereitstellen, können die drei Cyclen CCy und die drei Cyclen DCy bei jedem Auftreten gleich oder verschieden sein und trotzdem einer facialen oder meridionalen Koordination im Sinne dieser Anmeldung entsprechen. Als identische Donoratome werden solche verstanden, die aus den gleichen Elementen (z. B. Kohlenstoff bzw. Stickstoff) bestehen, unabhängig ob diese Elemente in unterschiedliche Strukturen eingebaut sind. Ebenso lässt sich diese Definition auf Metallkomplexe übertragen, welche allgemein drei neutrale und drei anionische koordinierende Atome enthalten, so dass sich diese Definition auch verwenden lässt, wenn beispielsweise ein Ligand über ein neutrales und ein anionisches Stickstoffatom koordiniert.

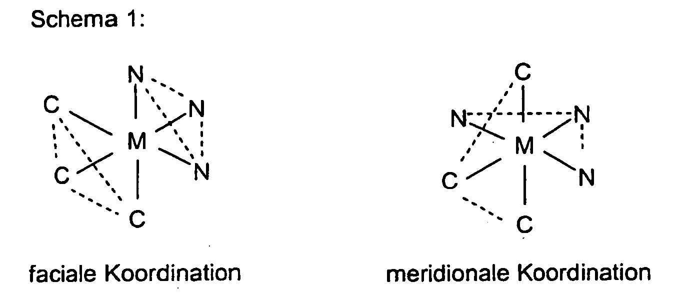

Bevorzugte erfindungsgemäße Metalledukte sind solche, in denen das Symbol M für Iridium oder Platin, insbesondere für Iridium steht.

Bevorzugte Verbindungen gemäß Formel (2) sind solche, in denen der Index z für 1 bis 10 steht, besonders bevorzugt für 1 bis 3. Bevorzugte Verbindungen gemäß Formel (2) sind weiterhin solche, in denen der Index y für 0 bis 10 steht, besonders bevorzugt für 0 bis 3 steht.

Bevorzugte Verbindungen gemäß Formel (3) sind solche, in denen der Index z für 0 bis 10 steht, besonders bevorzugt für 0 bis 3. Bevorzugte Verbindungen gemäß Formel (3) sind weiterhin solche, in denen der Index y für 0 bis 10 steht, besonders bevorzugt für 0 bis 3, ganz besonders bevorzugt für 0.

Dabei muss es sich bei den Indizes z und y nicht um ganze Zahlen handeln, da die Komplexe auch nicht-stöchiometrische Mengen Wasser und HX enthalten können. Gerade der Wasseranteil kann je nach Charge schwanken, da es sich um hygroskopische Metallsalze handelt. Der Anteil von Wasser im Ausgangsprodukt hat jedoch keinen Einfluss auf die Reaktion, da der Reaktionsmischung eine größere Menge Wasser zugesetzt wird.

Bevorzugte Metalledukte der Formeln (2), (3) und (4) sind weiterhin solche, in denen das Symbol X, gleich oder verschieden bei jedem Auftreten, für Chlor oder Brom, besonders bevorzugt für Chlor steht.

Bevorzugte Liganden sind solche, in denen das Symbol CCy, gleich oder verschieden bei jedem Auftreten, für eine aromatische oder heteroaromatische Gruppe mit 5 bis 20 aromatischen Ringatomen steht, welche einen oder mehrere Substituenten R tragen kann. Die aromatische bzw. heteroaromatische Gruppe CCy kann auch kondensiert sein. Dabei muss der unkoordinierte Ligand in mindestens einer ortho-Position zur Bindung von DCy ein unsubstituiertes Kohlenstoffatom oder eine NH-Gruppe aufweisen, welche dann an das Metall binden kann. Besonders bevorzugt bindet die Gruppe CCy über ein Kohlenstoffatom an das Metall. Bevorzugte aromatische Gruppen CCy sind solche mit 6 bis 20 C-Atomen, bevorzugt 6 bis 14 C-Atomen, besonders bevorzugt 6 oder 10 C-Atomen, welche auch durch einen oder mehrere Reste R substituiert sein können. Ganz besonders bevorzugte aromatische Gruppen sind Phenyl, Naphthyl, Anthryl, Fluorenyl und Phenanthrenyl, insbesondere Phenyl und Naphthyl, welche jeweils durch einen oder mehrere Reste R substituiert sein können. Bevorzugte heteroaromatische Gruppen CCy sind solche mit mindestens einem Heteroatom und mindestens zwei C-Atomen, wobei die Summe aus Heteroatomen und C-Atomen mindestens 5 ergeben muss. Die Heteroatome sind bevorzugt ausgewählt aus N, S und/oder O. Bevorzugte heteroaromatische Gruppen enthalten 5 bis 14 aromatische Ringatome, besonders bevorzugt 5, 6, 9 oder 10 aromatische Ringatome. Besonders bevorzugte heteroaromatische Gruppen sind abgeleitet von Thiophen, Pyrrol, Furan, Imidazol, Pyrazol, Pyridin, Pyrazin, Pyrimidin, Pyridazin, Benzothiophen, Indol, Carbazol, Benzofuran, Chinolin, Isochinolin oder Chinoxalin, welche jeweils durch einen oder mehrere Reste R substituiert sein können.

Bevorzugte Liganden sind weiterhin solche, in denen das Symbol DCy, gleich oder verschieden bei jedem Auftreten, für eine cyclische Gruppe mit 5 bis 20 Ringatomen steht, welche ein neutrales Stickstoffatom in ortho-Position zur Bindung von CCy als Donoratom enthält. Dabei ist der Stickstoff bevorzugt entweder in einer Imin-Funktionalität gebunden oder Teil eines heteroaromatischen Systems. Der Cyclus DCy enthält mindestens ein Stickstoffatom und, mindestens zwei Kohlenstoffatome, wobei die Summe aller Heteroatome und Kohlenstoffatome mindestens 5 ergeben muss. Bevorzugt enthält DCy 5 bis 20 aromatische Ringatome, besonders bevorzugt 5 bis 14 aromatische Ringatome, ganz besonders bevorzugt 5, 6, 9 oder 10 aromatische Ringatome. Besonders bevorzugte Cyclen DCy sind ausgewählt aus Pyridin, Chinolin, Isochinolin, Chinoxalin, Benzpyrimidin, 2-Azaanthracen, Phenanthridin, Oxazol, Thiazol, Benzoxazol oder Benzthiazol, insbesondere Pyridin, Chinolin, Isochinolin oder Benzpyrimidin, welche jeweils durch einen oder mehrere Reste R substituiert sein können.

Die Reaktion wird unter Zusatz eines Salzes, welches mindestens zwei Sauerstoffatome enthält, durchgeführt. Dabei kann es sich bei dem Salz sowohl um organische, wie auch um anorganische Salze handeln. Auch zwitterionische Verbindungen (so genannte innere Salze) sind Salze im Sinne dieser Erfindung und kommen für das erfindungsgemäße Verfahren in Frage. Bevorzugt ist mindestens eines der Sauerstoffatome negativ geladen. Weiterhin bevorzugt sind die Sauerstoffatome in einer 1,3-, 1,4- oder 1,5-Anordnung in dem Salz gebunden (Schema 2, wobei auch Bindung an andere Zentralatome als Kohlenstoff möglich ist, beispielsweise an Schwefel, Stickstoff oder Phosphor), das heißt, sie binden bevorzugt an dasselbe Zentralatom (1,3-Anordnung), an benachbarte Zentralatome (1,4-Anordnung) oder jeweils an das übernächste Zentralatom (1,5-Anordnung). Besonders bevorzugt sind die Sauerstoffatome in dem Salz in 1,3- oder 1,4-Anordnung gebunden, ganz besonders bevorzugt in 1,3-Anordnung. Es ist auch möglich, dass das Salz *in situ* durch Zusatz einer Base gebildet wird.

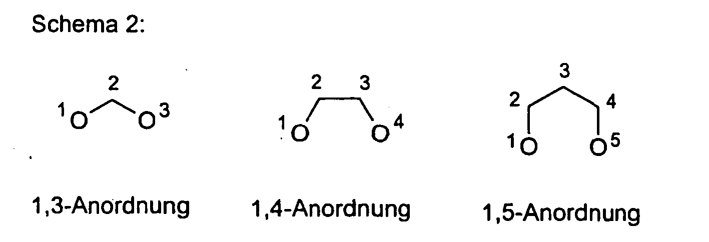

Unter einem inneren Salz bzw. einem Zwitterion im Sinne dieser Erfindung wird eine Verbindung verstanden, die mindestens eine anionische Gruppe enthält, welche mindestens zwei Sauerstoffatome enthält, und die im selben Molekül mindestens eine kationische Gruppe enthält. Ein solches inneres Salz kann beispielsweise entstehen intramolekulare Säure-Base-Reaktion zwischen einer sauren Gruppe und einer basischen Gruppe im selben Molekül, beispielsweise zwischen einer Carbonsäuregruppe und einer Aminogruppe in einer Aminocarbonsäure.

Bevorzugte anorganische Salze sind Alkali-, Erdalkali-, Ammonium-, Tetraalkylammonium-, Tetraalkylphosphonium- und/oder Tetraarylphosphoniumsalze von Carbonat, Hydrogencarbonat, Sulfat, Hydrogensulfat, Sulfit, Hydrogensulfit, Nitrat, Nitrit, Phosphat, Hydrogenphosphat, Dihydrogenphosphat, Borat, insbesondere die Alkali-, die Ammonium- und die Tetraalkylammoniumsalze. In allen diesen Salzen sind die Sauerstoffatome in einer 1,3-Anordnung gebunden.

Bevorzugte organische Salze sind die Alkali-, Erdalkali-, Ammonium-, Tetraalkylammonium-, Tetraalkylphosphonium und/oder Tetraarylphosphoniumsalze organischer Carbonsäuren mit 1 bis 20 C-Atomen, insbesondere Formiat, Acetat, Fluoracetat, Trifluoracetat, Trichloracetat, Propionat, Butyrat, Oxalat, Benzoat, Pyridincarboxylat, organischer Sulfonsäuren mit 1 bis 20 C-Atomen, insbesondere MeSO₃⁻, EtSO₃⁻, PrSO₃⁻, F₃CSO₃⁻, C₄F₉SO₃⁻, Phenyl-SO₃⁻, ortho-, meta- oder para-Tolyl-SO₃⁻, sowie von α-Ketocarboxylaten, wie z. B. Salze der Brenztraubensäure, β-Ketoketonaten, insbesondere Acetylacetonat, β-Ketocarboxylaten, wie z. B. Salze der β-Ketobuttersäure, und Salze von Brenzcatechin und Salicylsäure, insbesondere jeweils solche mit bis zu 20 C-Atomen. Dabei sind in den Salzen der organischen Carbonsäuren und organischen Sulfonsäuren die Sauerstoffatome in einer 1,3-Anordnung gebunden, in Oxalat sowohl in einer 1,3- wie auch in einer 1,4-Anordnung, in β-Ketoketonaten in einer 1,5-Anordnung und in β-Ketocarboxylaten in einer 1,3- wie auch in einer 1,5-Anordnung.

Die Carboxylate und Sulfonate können dabei lineare, verzweigte oder cyclische Grundstruktur aufweisen und können aliphatisch und/oder aromatisch sein. Weiterhin können sie mit den vorne definierten Gruppen R substituiert oder unsubstituiert sein.

Unter Alkalisalzen sind Lithium-, Natrium-, Kalium-, Rubidium- und Caesiumsalze zu verstehen, bevorzugt Natrium- und Kaliumsalze. Unter Erdalkalisalzen sind Beryllium-, Magnesium-, Calcium-, Strontium- und Bariumsalze zu verstehen, bevorzugt Magnesiumsalze. Unter Tetraalkylammoniumsalzen sind bevorzugt solche mit insgesamt 4 bis 40 C-Atomen, insbesondere Tetramethylammonium, Tetraethylammonium, Tetrapropylammonium und Tetrabutylammonium, zu verstehen. Unter Tetraalkylphosphoniumsalzen sind bevorzugt solche mit insgesamt 4 bis 40 C-Atomen, insbesondere Tetramethylphosphonium, Tetraethylphosphonium, Tetrapropylphosphonium und Tetrabutylphosphonium, zu verstehen. Unter Tetraarylphosphoniumsalzen sind bevorzugt solche mit insgesamt 20 bis 40 C-Atomen, insbesondere Tetraphenylphosphonium und Tetratolylphosphonium, zu verstehen. Dabei werden vorwiegend Salze eingesetzt, die im Reaktionsmedium löslich sind, bevorzugt solche, die in einer Konzentration von mindestens 0.001 mol/l löslich sind, besonders bevorzugt in einer Konzentration von mindestens 0.01 mol/l, ganz besonders bevorzugt in einer Konzentration von mindestens 0.1 mol/l.

Bevorzugte innere Salze sind Aminocarbonsäuren, bevorzugt mit 2 bis 20 C-Atomen, die in neutralem Medium überwiegend zwitterionisch vorliegen, insbesondere α-Aminosäuren, wie Glycin, Alanin, Arginin, Asparagin, Asparaginsäure, Glutamin, Glutaminsäure, Histidin, Leucin, Isoleucin, Lysin, Phenylalanin, Prolin, Serin, Threonin, Typtophan, Tyrosin oder Valin, ebenso β- und γ-Aminosäuren, wie γ-Aminobuttersäure, aromatische Aminosäuren, wie 2-Aminobenzoesäure, 3-Aminobenzoesäure, 4-Aminobenzoesäure, Polyaminocarbonsäuren, wie EDTA und Derivate von EDTA, sowie die entsprechenden N-alkylierten Aminocarbonsäuren der oben genannten Verbindungsklassen, wobei die Alkylgruppen bevorzugt 1 bis 10 C-Atome enthalten, besonders bevorzugt 1, 2, 3 oder 4 C-Atome, wie beispielsweise N,N-Dimethylglycin, N,N-Diethylglycin, N,N-Dimethylalanin, 4-N,N-Dimethylaminobuttersäure, etc. Bevorzugte innere Salze sind weiterhin Aminosulfonsäuren, bevorzugt mit 2 bis 20 C-Atomen, wie beispielsweise Taurin, sowie die entsprechenden N-alkylierten Aminosulfonsäuren, wobei die Alkylgruppen bevorzugt 1 bis 10 C-Atome enthalten, besonders bevorzugt 1, 2, 3 oder 4 C-Atome. Weiterhin bevorzugt sind die Salze dieser Aminosäuren bzw. Aminosulfonsäuren, die durch Abstraktion eines oder mehrerer Protonen dieser Verbindungen erhalten werden, wobei als Kationen die oben genannten Kationen in Frage kommen.

Das bevorzugte molare Verhältnis von Metall zum zugesetzten Salz beträgt 1:1 bis 1:1000, besonders bevorzugt 1:5 bis 1:300, ganz besonders bevorzugt 1:10 bis 1:150. Daher beträgt das molare Verhältnis der Metallverbindung gemäß Formel (2) bzw. Formel (3) zum zugesetzten Salz bevorzugt 1:1 bis 1:1000, besonders bevorzugt 1:5 bis 1:300, ganz besonders bevorzugt 1:10 bis 1:150 und das molare Verhältnis der Metallverbindung gemäß Formel (4) zum zugesetzten Salz bevorzugt 1:2 bis 1:2000, besonders bevorzugt 1:10 bis 1:600, ganz besonders bevorzugt 1:20 bis 1:300.

Die Reaktion wird erfindungsgemäß in einem Lösemittelgemisch aus einem organischen Lösemittel und Wasser durchgeführt, bevorzugt in homogener Lösung. Dabei bezieht sich homogen auf die Lösemittelmischung, die Edukte und das zugesetzte Salz, nicht jedoch auf das Reaktionsprodukt, welches im Allgemeinen aus der Reaktionsmischung ausfällt. Bevorzugt sind daher organische Lösemittel, welche mit Wasser mischbar sind, insbesondere solche, welche in beliebigem Verhältnis mit Wasser mischbar sind. Dies sind insbesondere polar protische und polar aprotische Lösemittel.

Bevorzugte polar protische Lösemittel sind Alkohole, insbesondere Alkohole mit 1 bis 5 C-Atomen, beispielsweise Methanol, Ethanol, n-Propanol, iso-Propanol, n-Butanol, iso-Butanol oder tert-Butanol, oder auch Diole oder Polyalkohole, beispielsweise Ethylenglycol, Propylenglycol, Glycerin, Polyethylenglycole, beispielsweise PEG600 und PEG1000, sowie Alkoxyalkohole, beilspielsweise Methoxyethanol oder Ethoxyethanol.

Bevorzugte polar aprotische Lösemittel sind wassermischbare offenkettige Ether, beispielsweise Triethylenglycoldimethylether, Poly(ethylenglycol)-dimethylether, wassermischbare cyclische Ether, wie Dioxan oder THF, sowie DMSO, NMP und DMF.

Besonders bevorzugt wird als organisches Lösemittel ein polar aprotisches Lösemittel verwendet, ganz besonders bevorzugt ein cyclischer wassermischbarer Ether, insbesondere Dioxan.

Erfindungsgemäß ist der Anteil von Wasser im Reaktionsmedium mindestens 2 Vol.-%. Bevorzugt liegt der Anteil von Wasser im Bereich von 5 bis 90 Vol.-%, besonders bevorzugt im Bereich von 7 bis 75 Vol.-%, ganz besonders bevorzugt im Bereich von 10 bis 60 Vol.-%. Insbesondere geeignet ist ein Wasseranteil von 40 bis 60 Vol.-%.

Die Umsetzung wird bevorzugt in einem Temperaturbereich von 20 bis 250 °C durchgeführt, besonders bevorzugt von 40 bis 150 °C, ganz besonders bevorzugt von 50 bis 100 °C. Diese Reaktionsbedingungen, die deutlich milder sind als die Reaktionsbedingungen gemäß dem Stand der Technik, bieten den Vorteil, dass die Reaktion auch mit thermisch und/oder chemisch empfindlichen Liganden durchgeführt werden kann und dass bei diesen Temperaturen keine Ligandenaustauschreaktionen stattfinden, so dass durch dieses Verfahren auch heteroleptische Komplexe mit hoher Ausbeute, Selektivität und Reinheit zugänglich sind. Je nach Lösemittelgemisch kann die Reaktion bei diesen Temperaturen unter Rückfluss durchgeführt werden. So wird die Reaktion in einer Mischung aus Dioxan und Wasser bevorzugt unter Rückfluss durchgeführt. Dies entspricht bei einer 1:1 Mischung einer Temperatur von ca. 85-90 °C. Die Reaktion kann auch unter Druck, beispielsweise im Autoklaven, durchgeführt werden.

Die Konzentration der Metall-Ausgangsverbindung gemäß Formel (2) bzw. Formel (3) liegt bevorzugt im Bereich von 0.5 mmol/l bis 100 mmol/l, besonders bevorzugt im Bereich von 1 bis 30 mmol/l, ganz besonders bevorzugt im Bereich von 2 bis 10 mmol/l. Die Konzentration der Metall-Ausgangsverbindung gemäß Formel (4) liegt bevorzugt im Bereich von 1 bis 1000 mmol/l, besonders bevorzugt im Bereich von 5 bis 500 mmol/l, ganz besonders bevorzugt im Bereich von 10 bis 100 mmol/l.

Das bevorzugte molare Verhältnis der Metall-Verbindung gemäß Formel (2) bzw. Formel (3) zum Liganden gemäß Formel (5) beträgt 1:1 bis 1:60, besonders bevorzugt 1:3 bis 1:10, ganz besonders bevorzugt 1:3 bis 1:8. Das bevorzugte molare Verhältnis der Metall-Verbindung gemäß Formel (4) zum Liganden gemäß Formel (5) beträgt 1:1 bis 1:100, besonders bevorzugt 1:2 bis 1:70, ganz besonders bevorzugt 1:2 bis 1:50.

Da der Ligand üblicherweise im Überschuss eingesetzt wird, teilweise sogar in erheblichem Überschuss, kann es insbesondere bei aufwändig synthetisierbaren Liganden sinnvoll sein, diesen nach der Reaktion wiederzugewinnen. Dies kann beispielsweise durch Extraktion der Mutterlauge mit einem nicht wassermischbaren Lösemittel erfolgen.

Die Reaktion wird bevorzugt innerhalb von 1 bis 100 h durchgeführt, besonders bevorzugt innerhalb von 5 bis 50 h. Es fällt auf, dass die Reaktion trotz der milderen Reaktionsbedingungen deutlich schneller abläuft als Reaktionen gemäß dem Stand der Technik.

Eine weitere Beschleunigung der Reaktion kann beispielsweise unter Einsatz von Mikrowellenstrahlung erreicht werden. Wie Orthometallierungsreaktionen allgemein in der Mikrowelle durchgeführt werden können, ist beispielsweise in WO 04/108738 beschrieben. Die Verwendung von Mikrowellenstrahlung ist im erfindungsgemäßen Verfahren jedoch nicht unbedingt erforderlich, um gute Ausbeuten zu erzielen.

Durch das erfindungsgemäße Verfahren lassen sich selektiv die facialen bzw. die meridionalen Metallkomplexe herstellen. Dabei wurde gefunden, dass insbesondere bei Verwendung von Metallcarboxylaten, beispielsweise Acetat, die meridionalen Metallkomplexe entstehen, während bei Verwendung von Aminosäuren, alkylierten Aminosäuren, Aminosulfonsäuren, alkylierten Aminosulfonsäuren und rein anorganischen Salzen die entsprechenden facialen Metallkomplexe entstehen.

Bevorzugt ist weiterhin ein Verfahren zur Herstellung eines facialen tris-ortho-metallierten Metallkomplexes gemäß Formel (1), dadurch gekennzeichnet, dass zunächst ein meridionaler Komplex durch ein erfindungsgemäßes Verfahren gemäß der obigen Beschreibung hergestellt wird, gefolgt von einem Reaktionsschritt zur Überführung des meridionalen in das faciale Isomer des Komplexes. Diese Umwandlung des meridionalen in das faciale Isomer kann durch Zuführung von Energie, insbesondere thermischer Energie oder elektromagnetischer Strahlung (UV-Strahlung, Mikrowellenstrahlung, etc.), durchgeführt werden. Dabei kann der Umwandlungsschritt entweder direkt in der Reaktionslösung im Anschluss an die Reaktion als Eintopfverfahren durchgeführt werden, oder er kann in einem separaten Reaktionsschritt nach Isolation des meridionalen Metallkomplexes durchgeführt werden. Wie die Umwandlung vom meridionalen zum facialen Komplex durchgeführt werden kann, ist beispielsweise von Thompson *et al.* beschrieben (A. B. Tamayo, B. D. Alleyne, P. I. Djurovich, S. Lamansky, I. Tsyba, N. N. Ho, M. E. Thompson, J. Am. Chem. Soc. 2003, 125, 7377-7387).

Ein weiterer Gegenstand der Erfindung ist die Verwendung des Verfahrens zur Herstellung difunktionalisierter Metallkomplexe, insbesondere zur Herstellung von Dibromverbindungen. Diese eignen sich insbesondere für den Einsatz als Monomere zur Herstellung von Polymeren. Durch das erfindungsgemäße Verfahren werden diese Monomere erstmalig einfach und mit einer großen Bandbreite an Liganden gut zugänglich.

Da durch das erfindungsgemäße Verfahren heteroleptische Metallkomplexe besonders einfach, selektiv und in guten Ausbeuten zugänglich sind, beispielsweise oktaedrische Komplexe, die an zwei der drei Liganden mit Brom, Boronsäure oder Boronsäureestern, beispielsweise Boronsäureglycolester oder Boronsäurepinacolester, als polymerisierbare funktionelle Gruppe substituiert sind und am dritten Liganden keine polymerisierbare Gruppe tragen, sind derartige Polymere, Oligomere oder Dendrimere ebenfalls besser zugänglich als gemäß dem Stand der Technik, wobei die Polymere, Oligomere oder Dendrimere konjugiert, teilkonjugiert oder nicht-konjugiert sein können. Dabei sind die funktionellen Gruppen der difunktionalisierten Verbindungen bevorzugt Halogen, insbesondere Brom, oder Boronsäure bzw. Boronsäurederivate.

Das erfindungsgemäße Verfahren bietet die folgenden Vorteile gegenüber dem Stand der Technik:
1. Das erfindungsgemäße Verfahren ermöglicht einen Zugang zu tris-ortho-metallierten Metallkomplexen aus einfach zugänglichem Metallhalogenid in einem Schritt und in sehr guter Ausbeute, während die Verfahren gemäß dem Stand der Technik von aufwändigeren Edukten, beispielsweise verschiedenen Metallketoketonat-Komplexen, ausgehen oder deutlich schlechtere Ausbeuten aufweisen.
2. Ein weiterer Vorteil des erfindungsgemäßen Verfahrens sind die milden Reaktionsbedingungen. Dies ist überraschend, da ähnliche Verfahren gemäß dem Stand der Technik, die unter Zusatz von Acetylacetonat oder anorganischen Basen, wie Hydrogencarbonat ablaufen, die jedoch in der Reaktionsmischung kein Wasser enthalten, bei deutlich drastischeren Reaktionsbedingungen (Einsatz von Mikrowellenstrahlung, Reaktion bei über 190 °C) ablaufen. Diese Wirkung von Wasser auf die Reaktion ist ein überraschendes und nicht vorhersehbares Ergebnis, da im Stand der Technik bei einer Reaktion in einer Mischung aus Ethoxyethanol und Wasser ohne Zusatz eines Salzes nur eine Ausbeute von 10 % erhalten wurde.
3. Durch die milden Reaktionsbedingungen lässt sich das Verfahren auch zur Synthese von Metallkomplexen mit thermisch und/oder chemisch empfindlichen Liganden nutzen, die bei Verfahren gemäß dem Stand der Technik zu unerwünschten Nebenreaktionen führen.
4. Durch die milden Reaktionsbedingungen lassen sich selektiv heteroleptische Metallkomplexe synthetisieren. Diese sind nach dem Stand der Technik schwierig zu synthetisieren, da bei hohen Temperaturen immer Ligandenaustauschreaktionen stattfinden, welche zu Produktmischungen führen. Dieses Verfahren ist daher auch besonders gut geeignet zur Herstellung heteroleptischer Komplexe, welche in Polymerisationsreaktionen als Monomere eingesetzt werden können.
5. Durch das erfindungsgemäße Verfahren können die meridionalen Komplexe, die ansonsten nur aufwändig und unter sehr genauer Kontrolle der Reaktionsbedingungen zugänglich sind, einfach und selektiv synthetisiert werden. Da das meridionale Isomer gegenüber dem facialen rotverschoben emittiert, kann es bevorzugt zur Erzeugung roter Emission verwendet werden. Der meridionale Komplex kann, wenn gewünscht, auch selektiv in den entsprechenden facialen Komplex überführt werden.

Die vorliegende Erfindung wird durch die nachfolgenden Beispiele näher erläutert, ohne diese auf die Beispiele einschränken zu wollen. Dem Fachmann auf dem Gebiet der organischen und metallorganischen Synthese ist es ohne weitere erfinderische Tätigkeit möglich, an weiteren Systemen die erfindungsgemäßen Umsetzungen durchzuführen. Insbesondere kann das Verfahren ohne weitere erfinderische Tätigkeit an unterschiedlich substituierten Systemen durchgeführt werden oder auch an Systemen, welche statt Phenyl oder Pyridin bzw. Isochinolin bzw. Benzpyrimidin andere Aryl- oder Heteroarylgruppen enthalten.

### Beispiele

Die nachfolgenden Synthesen werden, sofern nicht anders angegeben, unter einer Schutzgasatmosphäre durchgeführt. Iridium(III)chlorid Hydrat kann von der Firma Heraeus bezogen werden und entspricht nach Iridium- und Wassergehaltsbestimmung der Formel IrCl₃ * H₂O. Die einfachen substituierten 2-Phenylpyridine können von der Firma Aldrich bzw. der Firma ABCR bezogen bzw. nach gängigen Literaturvorschriften dargestellt werden.

### Vergleichsbeispiel 1: Synthese ohne Zusatz von Wasser

Ein Gemisch aus 10 mmol IrCl₃ * H₂O, 60 mmol 2-Phenylpyridin und 300 mmol Natriumacetat wird mit 500 ml Dioxan versetzt und 30 h bei 80 °C gerührt. Die Reaktion verläuft nicht in homogener Lösung. Es bildet sich ein Bodensatz undefinierter Zusammensetzung. Es kann kein tris-ortho-metallierter Metallkomplex isoliert werden.

### Vergleichsbeispiel 2: Synthese ohne Zusatz von Salz

Ein Gemisch aus 10 mmol IrCl₃ * H₂O und 60 mmol 2-Phenylpyridin wird mit 500 ml Dioxan und 500 ml Wasser versetzt und 30 h bei 80 °C gerührt. Nach Erkalten wird der Niederschlag abgesaugt. Es wird der dimere Chloro-verbrückte Iridiumkomplex, [PhPy]₂IrCl₂Ir[PhPy]₂ in ca. 90 % Ausbeute erhalten.

### Beispiel 1: Synthese homoleptischer meridionaler Metallkomplexe aus IrCl₃ * H₂O - Allgemeine Synthesevorschrift

Ein Gemisch aus 10 mmol IrCl₃ * H₂O, 60 mmol des Liganden gemäß Formel (5) und dem Salz wird mit dem organischen Lösemittel und Wasser versetzt und 30 h bei 80 °C gerührt. Die Ligandenstrukturen, das Salz, die Lösemittel und die jeweiligen Mengen sind in Tabelle 1 zusammen mit den Ausbeuten aufgeführt. Nach Erkalten wird der Niederschlag abgesaugt (P4), dreimal mit je 50 ml eines Gemischs aus 50 ml 1 N wässriger Salzsäure und 150 ml Ethanol, dreimal mit je 50 ml eines Gemischs aus 100 ml Wasser und 100 ml Ethanol und dreimal mit je 50 ml Ethanol gewaschen und bei 70 °C im Vakuum getrocknet. Die Reinheit der nach diesem Verfahren erhaltenen Produkte beträgt ohne weitere Aufreinigung mindestens 99.0 % nach ¹H-NMR.

**Tabelle 1:**

| Bsp. | Ligand gemäß Formel (5) | Salz [mmol] | Lösemittel [ml] | Wasser [ml] | Produkt | Isomer | Ausbeute [%] |
|---|---|---|---|---|---|---|---|
| 1a) | 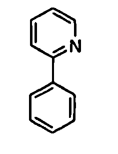 | NaAc 300 | Dioxan 500 | 500 | 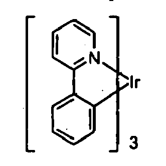 | *mer* | 83.4 |
| 1b) | s. Bsp 1a) | NaAc 300 | Dioxan 700 | 300 | s. Bsp 1a) | *mer* | 86.0 |
| 1c) | s. Bsp 1a) | NaAc 300 | Dioxan 600 | 400 | s. Bsp 1a) | *mer* | 78.1 |
| 1d) | s. Bsp 1a) | NaAc 100 | Dioxan 500 | 500 | s. Bsp 1a) | *mer* | 82.9 |
| 1e) | s. Bsp 1a) | NaAc 300 | 2-Ethoxyethanol 500 | 500 | s. Bsp 1a) | *mer* | 74.9 |
| 1f) | s. Bsp 1a) | NaAc 300 | THF 500 | 500 | s. Bsp 1a) | *mer* | 71.5 |
| 1g) | s. Bsp 1a) | KAc 300 | Dioxan 500 | 500 | s. Bsp 1a) | *mer* | 85.4 |
| 1h) | s. Bsp 1a) | NH₄Ac 300 | Dioxan 500 | 500 | s. Bsp 1a) | *mer* | 87.1 |
| 1i) | s. Bsp 1a) | Na-Benzoat 300 | Dioxan 500 | 500 | s. Bsp 1a) | *mer* | 88.2 |
| ij) | s. Bsp 1a) | Na-Propionat 300 | Dioxan 500 | 500 | s. Bsp 1a) | *mer* | 84.4 |
| 1k) | 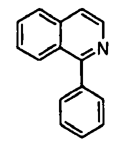 | NaAc 300 | Dioxan 500 | 500 | 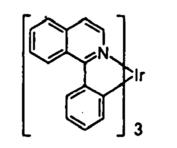 | *mer* | 91.6 |
| 1l) | 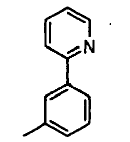 | NaAc 300 | Dioxan 500 | 500 | 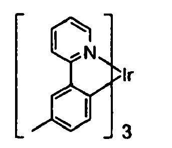 | *mer* | 89.8 |
| 1m) | 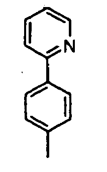 | NaAc 300 | Dioxan 500 | 500 | 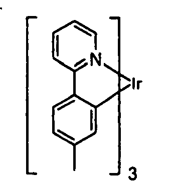 | *mer* | 77.5 |
| 1n) | 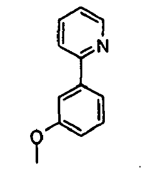 | NaAc 300 | Dioxan 500 | 500 | 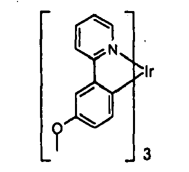 | *mer* | 85.8 |
| 1o) | 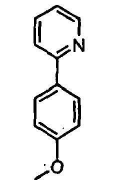 | NaAc 300 | Dioxan 500 | 500 | 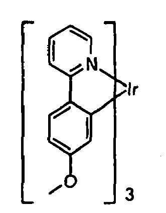 | *mer* | 78.6 |
| 1p) | 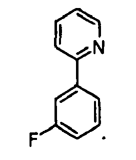 | NaAc 300 | Dioxan 500 | 500 | 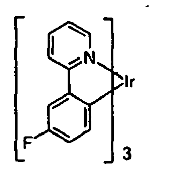 | *mer* | 82.4 |
| 1q) | 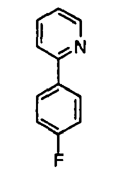 | NaAc 300 | Dioxan 500 | 500 | 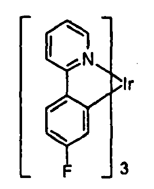 | *mer* | 76.7 |
| 1r) | 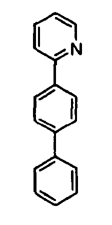 | NaAc 300 | Dioxan 700 | 300 | 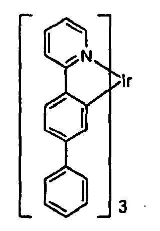 | *mer* | 85.5 |
| 1s) | 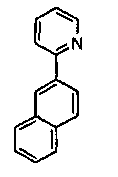 | NaAc 300 | Dioxan 700 | 300 | 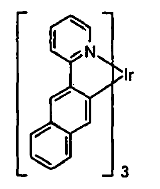 | *mer* | 88.0 |
| 1t) | 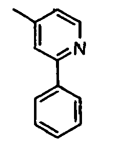 | NaAc 300 | Dioxan 500 | 500 | 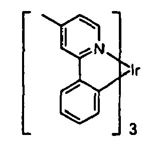 | *mer* | 75.0 |
| 1u) | 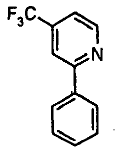 | NaAc 300 | Dioxan 500 | 500 | 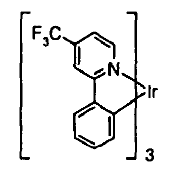 | *mer* | 91.4 |
| 1v) | 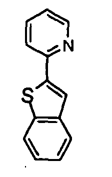 | NaAc 300 | Dioxan 500 | 500 | 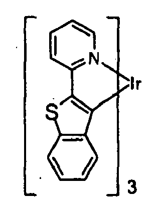 | *mer* | 81.2 |

| | | | | | | | |
|---|---|---|---|---|---|---|---|
| Anmerkungen: NaAc = Natriumacetat KAc = Kaliumacetat *mer* = meridional Bsp. 1f): Reaktionstemperatur 60 °C | | | | | | | |

### Beispiel 2: Synthese homoleptischer facialer Metallkomplexe aus IrCl₃ * H₂O - Allgemeine Synthesevorschrift

Ein Gemisch aus 10 mmol IrCl₃ * H₂O. 300 mmol des Liganden gemäß Formel (5) und dem Salz wird mit dem organischem Lösemittel und Wasser versetzt und 30 h bei 80 °C gerührt. Die Ligandenstrukturen, das Salz, die Lösemittel und die jeweiligen Mengen sind in Tabelle 2 zusammen mit den Ausbeuten aufgeführt. Nach Erkalten wird der Niederschlag abgesaugt (P4), dreimal mit je 50 ml eines Gemischs aus 50 ml 1 N wässriger Salzsäure und 150 ml Ethanol, dreimal mit je 50 ml eines Gemischs aus 100 ml Wasser und 100 ml Ethanol und dreimal mit je 50 ml Ethanol gewaschen und bei 70 °C im Vakuum getrocknet. Die Reinheit der nach diesem Verfahren erhaltenen Produkte beträgt ohne weitere Aufreinigung mindestens 99.0 % nach ¹H-NMR.

**Tabelle 2:**

| Bsp. | Ligand gem. Formel (5) | Salz [mmol] | Lösemittel [ml] | Wasser [ml] | Produkt | Isomer | Ausbeute [%] |
|---|---|---|---|---|---|---|---|
| 2a) | 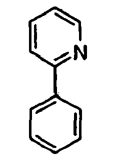 | Na₂SO₄ 300 | Dioxan 500 | 500 | 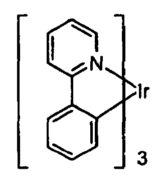 | *fac* | 88.0 |
| 2b) | s. Bsp. 2a) | NaHSO₄ 300 | Dioxan 500 | 500 | s. Bsp. 2a) | *fac* | 62.3 |
| 2c) | s. Bsp. 2a) | NH₄SO₄ 300 | Dioxan 500 | 500 | s. Bsp. 2a) | *fac* | 62.4 |
| 2d) | s. Bsp. 2a) | KH₂PO₄ 300 | Dioxan 500 | 500 | s. Bsp. 2a) | *fac* | 76.7 |
| 2e) | s. Bsp. 2a) | NaHCO₃ 300 | Dioxan 500 | 500 | s. Bsp. 2a) | *fac* | 79.7 |
| 2f) | 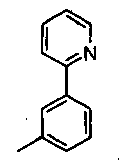 | KH₂PO₄ 300 | Dioxan 500 | 500 | 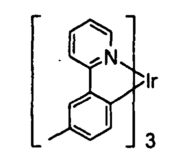 | *fac* | 83.1 |
| 2g) | 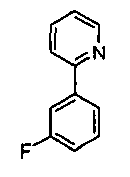 | KH₂PO₄ 300 | Dioxan 500 | 500 | 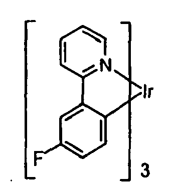 | *fac* | 74.1 |
| 2h) | 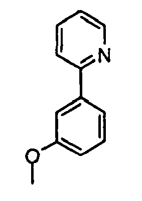 | KH₂PO₄ 300 | Dioxan 500 | 500 | 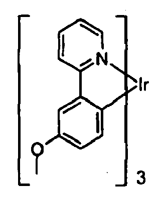 | *fac* | 89.2 |

| | | | | | | | |
|---|---|---|---|---|---|---|---|
| Anmerkungen: *fac* = facial | | | | | | | |

### Beispiel 3: Synthese homoleptischer facialer Metallkomplexe aus IrCl₃ * H₂O unter Zusatz von Aminosäuren / Aminosulfonsäuren - Allgemeine Synthesevorschrift

Ein Gemisch aus 10 mmol IrCl₃ * H₂O, 60 mmol des Liganden gemäß Formel (5) und der Aminosäure bzw. Aminosulfonsäure wird mit dem organischem Lösemittel und Wasser versetzt und 30 h bei 80 °C gerührt. Die Ligandenstrukturen, die Aminosäure bzw. Aminosulfonsäure, die Lösemittel und die jeweiligen Mengen sind in Tabelle 3 zusammen mit den Ausbeuten aufgeführt. Nach Erkalten wird der Niederschlag abgesaugt (P4), dreimal mit je 50 ml eines Gemischs aus 50 ml 1 N wässriger Salzsäure und 150 ml Ethanol, dreimal mit je 50 ml eines Gemischs aus 100 ml Wasser und 100 ml Ethanol und dreimal mit je 50 ml Ethanol gewaschen und bei 70 °C im Vakuum getrocknet. Die Reinheit der nach diesem Verfahren erhaltenen Produkte beträgt ohne weitere Aufreinigung mindestens 99.0 % nach ¹H-NMR.

**Tabelle 3:**

| Bsp. | Verb. gem. Formel 5 | Aminosäure / Aminosulfonsäure [mmol] | Lösemittel [ml] | Wasser [ml] | Produkt | Isomer | Ausbeute [%] |
|---|---|---|---|---|---|---|---|
| 3a) | 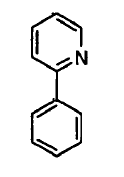 | Glycin 300 | Dioxan 500 | 500 | 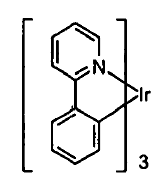 | *fac* | 91.3 |
| 3b) | s. Bsp. 3a) | Alanin 300 | Dioxan 500 | 500 | s. Bsp. 3a) | *fac* | 90.0 |
| 3c) | s. Bsp. 3a) | DMG 300 | Dioxan 500 | 500 | s. Bsp. 3a) | *fac* | 91.3 |
| 3d) | s. Bsp. 3a) | Glycin 100 | Dioxan 500 | 500 | s. Bsp. 3a) | *fac* | 88.6 |
| 3e) | s. Bsp. 3a) | Na-DMG 300 | Dioxan 500 | 500 | s. Bsp. 3a) | *fac* | 92.8 |
| 3f) | s. Bsp. 3a) | Na-DEG 300 | Dioxan 500 | 500 | s. Bsp. 3a) | *fac* | 92.6 |
| 3g) | s. Bsp. 3a) | DMAB 300 | Dioxan 500 | 500 | s. Bsp. 3a) | *fac* | 79.1 |
| 3h) | s. Bsp. 3a) | Taurin 300 | Dioxan 500 | 500 | s. Bsp. 3a) | *fac* | 85.9 |
| 3i) | 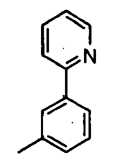 | DMG 300 | Dioxan 500 | 500 | 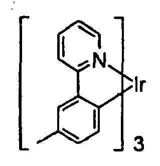 | *fac* | 86.1 |
| 3j) | 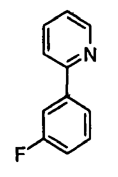 | DMG 300 | Dioxan 500 | 500 | 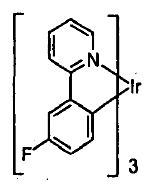 | *fac* | 82.1 |
| 3k) | 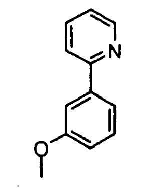 | DMG 300 | Dioxan 500 | 500 | 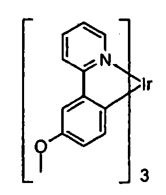 | *fac* | 88.0 |
| 3l) | 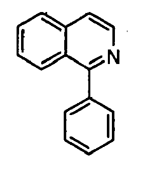 | DMG 300 | Dioxan 500 | 500 | 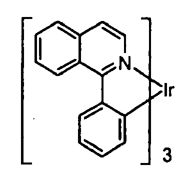 | *fac* | 82.7 |
| 3m) | 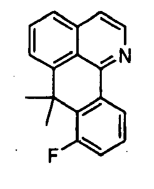 | DMG 300 | Dioxan 500 | 500 | 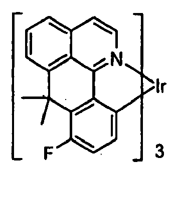 | *fac* | 89.6 |

| | | | | | | | |
|---|---|---|---|---|---|---|---|
| Anmerkungen: DMG = N,N-Dimethylglycin Na-DMG = Natrium-N,N-dimethylglycinat Na-DEG = Natrium-N,N-diethylglycinat DMAB = 4-(N,N-Dimethylamino)buttersäure *fac* = facial | | | | | | | |

### Beispiel 4: Synthese homoleptischer meridionaler und heteroleptischer Metallkomplexe aus dimeren Iridiumkomplexen - Allgemeine Synthesevorschrift

Ein Gemisch aus 5 mmol des dimeren Iridiumkomplexes gemäß Formel (4), 40 mmol des Liganden gemäß Formel (5) und 300 mmol Natriumacetat wird mit 500 ml Dioxan und 500 ml Wasser versetzt und 30 h bei 80 °C gerührt (Beispiele 4a) bis 4f)). Alternativ wird ein Gemisch aus 0.5 mmol des dimeren Iridiumkomplexes gemäß Formel (4), 6 mmol des Liganden gemäß Formel (5) und 30 mmol Natriumacetat mit 50 ml Dioxan und 50 ml Wasser versetzt und 30 h bei 80 °C gerührt (Beispiele 4g) bis 4t)). Dabei werden jeweils die entsprechenden meridionalen Komplexe erhalten. Die genauen Strukturen des Ausgangskomplexes und des Liganden sind in Tabelle 4 zusammen mit den Ausbeuten aufgeführt. Nach Erkalten wird der Niederschlag abgesaugt (P4), dreimal mit je 50 ml eines Gemischs aus 50 ml 1 N wässriger Salzsäure und 150 ml Ethanol, dreimal mit je 50 ml eines Gemischs aus 100 ml Wasser und 100 ml Ethanol und dreimal mit je 50 ml Ethanol gewaschen und bei 70 °C im Vakuum getrocknet. Die Reinheit der nach diesem Verfahren erhaltenen Produkte beträgt ohne weitere Aufreinigung mindestens 99.0 % nach ¹H-NMR.

Die dimeren Iridiumkomplexe gemäß Formel (4) können gemäß der Literatur (K. A. King, P. J. Spellane, R. J. Watts, J. Am. Chem. Soc. 1985, 107, 1431-1432) dargestellt werden, z. B.:
Eine Suspension aus 7,7-Dimethyl-8-fluor-dibenzo[de,h]chinolin (Darstellung gemäß WO 05/033244) (4.0 g, 15.20 mmol, 2.1 Äq.) und IrCl₃ * H₂O (2.55 g, 7.24 mmol) in 120 mL Ethoxyethanol und 40 mL Wasser wird 16 h unter Inertgasatmosphäre bei 130 °C gerührt. Der ausgefallene Feststoff wird unter Schutzgas abfiltriert, mit Wasser (100 mL), MeOH (100 mL) Diethylether (50 mL) und Hexan (100 mL) gewaschen. Man erhält 3.84 g (2.55 mmol) eines orangeroten Pulvers entsprechend 70.6 % d. Th.

**Tabelle 4:**

| Nr. | Ligand gemäß Formel (5) | Iridiumkomplex gemäß Formel (4) | Produkt | [%] |
|---|---|---|---|---|
| 4a) | 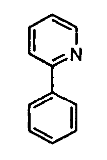 | 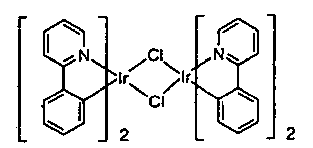 | 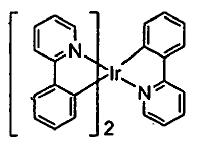 | 80.0 |
| 4b) | 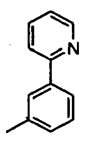 | 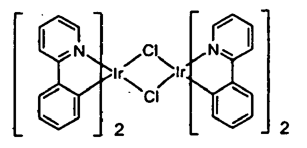 | 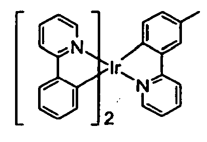 | 82.9 |
| 4c) | 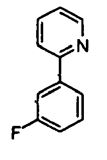 | 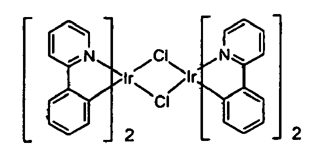 | 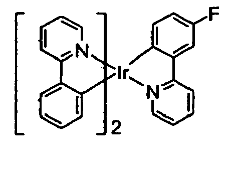 | 76.3 |
| 4d) | 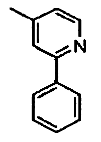 | 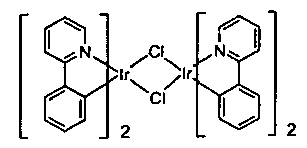 | 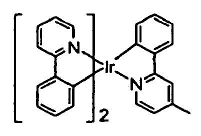 | 88.5 |
| 4e) | 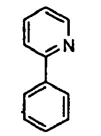 | 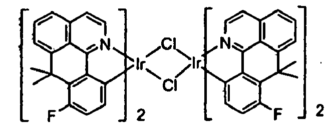 | 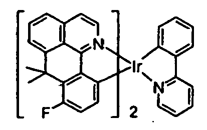 | 78.3 |
| 4f) | 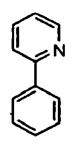 | 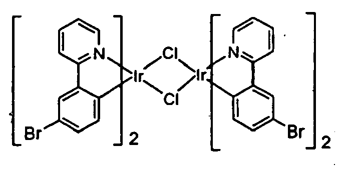 | 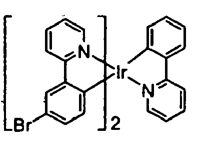 | 77.8 |
| 4g) | 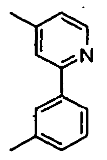 | 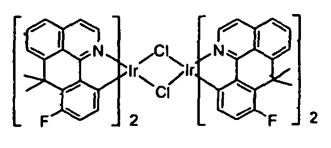 | 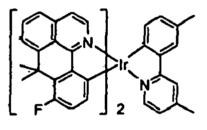 | 68.9 |
| 4h) | 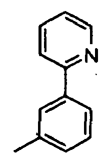 | 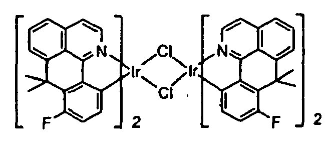 | 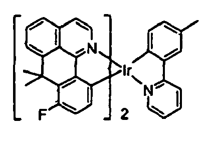 | 72.3 |
| 4i) | 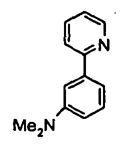 | 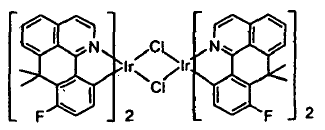 | 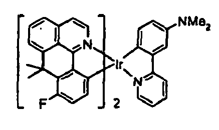 | 75.7 |
| 4j) | 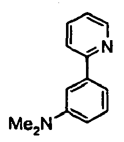 | 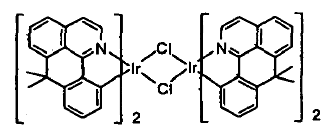 | 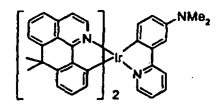 | 70.3 |
| 4k) | 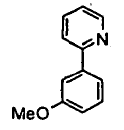 | 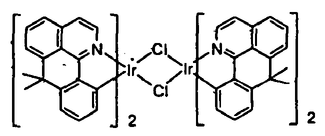 | 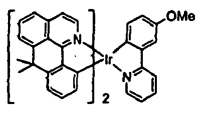 | 67.8 |
| 4l) | 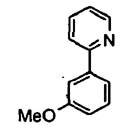 | 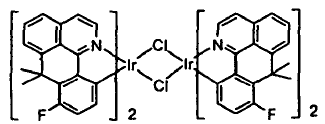 | 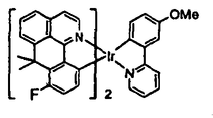 | 83.6 |
| 4m) | 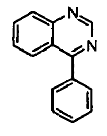 | 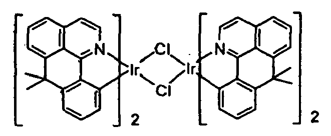 | 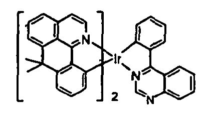 | 66.1 |
| 4n) | 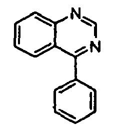 | 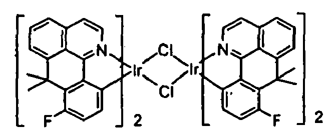 | 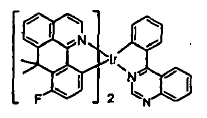 | 69.6 |
| 4o) | 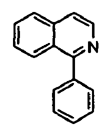 | 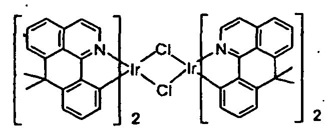 | 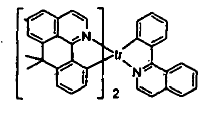 | 78.3 |
| 4p) | 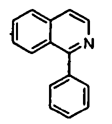 | 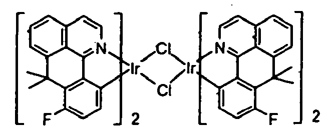 | 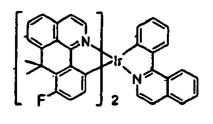 | 79.8 |
| 4q) | 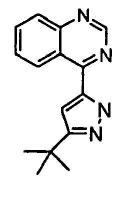 | 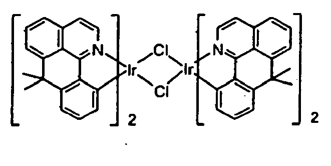 | 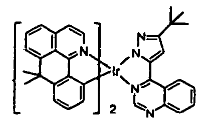 | 71.5 |
| 4r) | 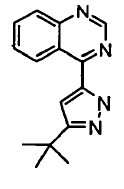 | 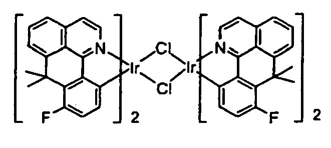 | 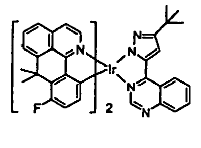 | 74.1 |
| 4s) | 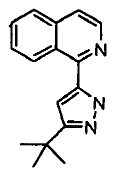 | 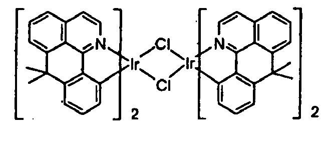 | 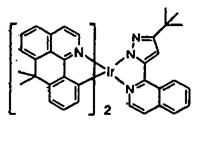 | 81.6 |
| 4t) | 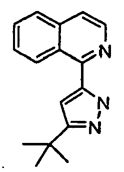 | 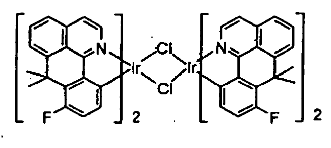 | 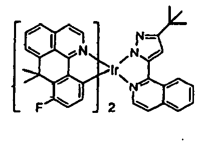 | 83.7 |

### Beispiel 5: Synthese homoleptischer facialer und heteroleptischer Iridiumkomplexe aus dimeren Iridiumverbindungen - Allgemeine Synthesevorschrift

Ein Gemisch aus 5 mmol des dimeren Iridiumkomplexes gemäß Formel (4), 40 mmol des Liganden gemäß Formel (5) und 300 mmol N,N-Dimethylglycin wird mit 500 ml Dioxan und 500 ml Wasser versetzt und 30 h bei 80 °C gerührt. Alternativ wird ein Gemisch aus 0.5 mmol des dimeren Iridiumkomplexes gemäß Formel (4), 6 mmol des Liganden gemäß Formel (5) und 30 mmol N,N-Dimethylglycin mit 50 ml Dioxan und 50 ml Wasser versetzt und 30 h bei 80 °C gerührt (Beispiele 5f) bis 5s)). Dabei entstehen die entsprechenden facialen Komplexe. Die genauen Strukturen des Komplexes und des Liganden sind in Tabelle 5 zusammen mit den Ausbeuten aufgeführt. Nach Erkalten wird der Niederschlag abgesaugt (P4), dreimal mit je 50 ml eines Gemischs aus 50 ml 1 N wässriger Salzsäure und 150 ml Ethanol, dreimal mit je 50 ml eines Gemischs aus 100 ml Wasser und 100 ml Ethanol und dreimal mit je 50 ml Ethanol gewaschen und bei 70 °C im Vakuum getrocknet. Die Reinheit der nach diesem Verfahren erhaltenen Produkte beträgt ohne weitere Aufreinigung mindestens 99.0 % nach ¹H-NMR.

**Tabelle 5:**

| Bsp. | Ligand gemäß Formel (5) | Iridiumkomplex gemäß Formel (4) | Produkt | [%] |
|---|---|---|---|---|
| 5a) | 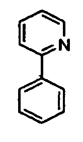 | 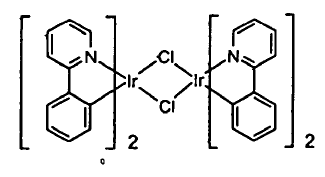 | 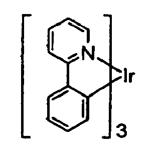 | 87.0 |
| 5b) | 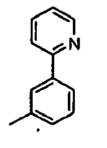 | 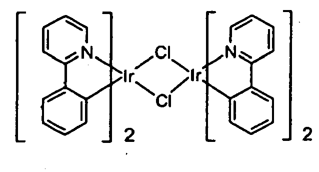 | 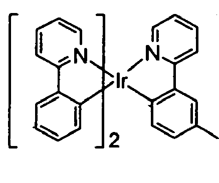 | 82.5 |
| 5c) | 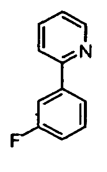 | 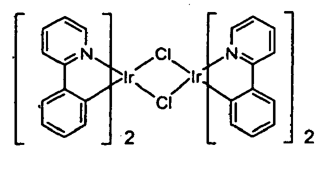 | 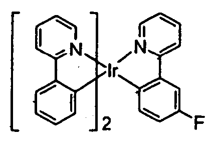 | 78.8 |
| 5d) | 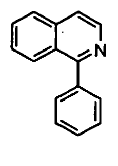 | 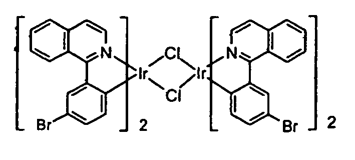 | 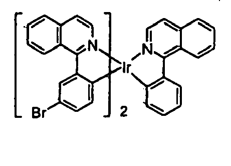 | 81.2 |
| 5e) | 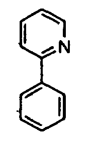 | 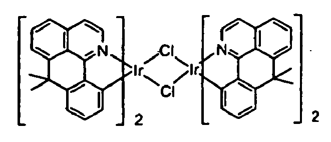 | 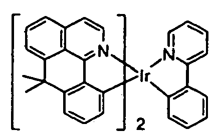 | 70.3 |
| 5f) | 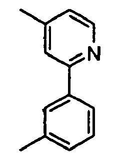 | 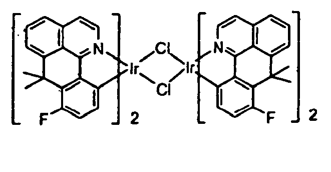 | 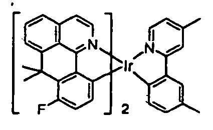 | 79.2 |
| 5g) | 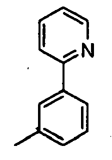 | 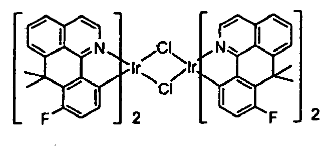 | 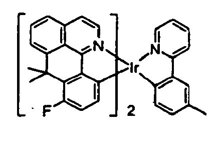 | 81.0 |
| 5h) | 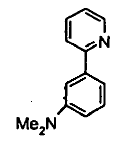 | 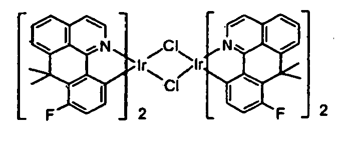 | 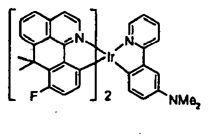 | 72.4 |
| 5i) | 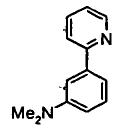 | 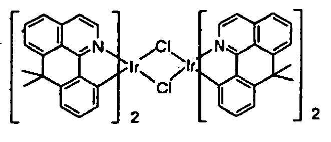 | 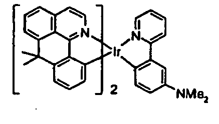 | 69.1 |
| 5j) | 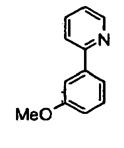 | 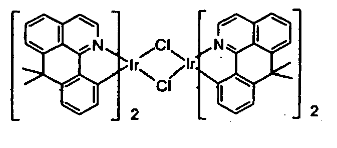 | 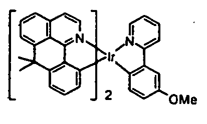 | 71.9 |
| 5k) | 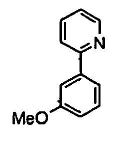 | 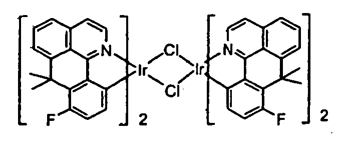 | 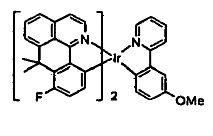 | 74.8 |
| 5l) | 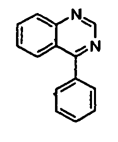 | 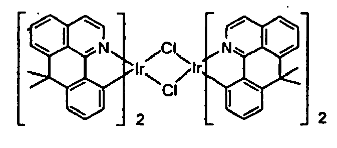 | 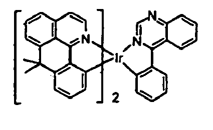 | 65.4 |
| 5m) | 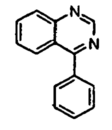 | 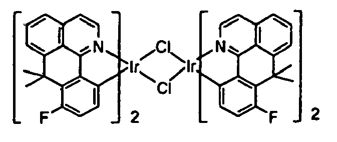 | 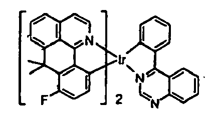 | 72.4 |
| 5n) | 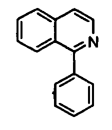 | 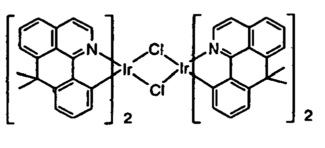 | 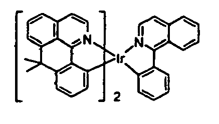 | 81.5 |
| 5o) | 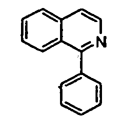 | 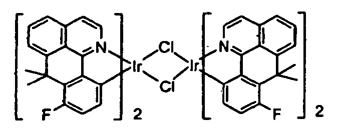 | 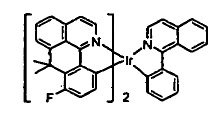 | 81.1 |
| 5p) | 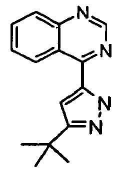 | 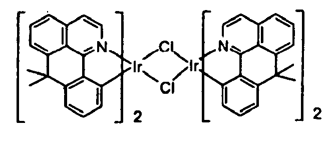 | 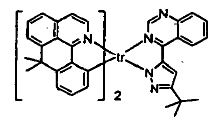 | 69.3 |
| 5q) | 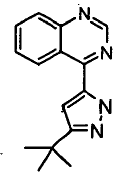 | 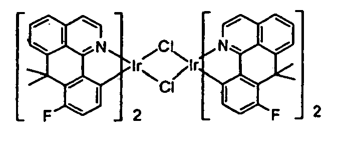 | 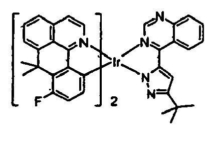 | 74.6 |
| 5r) | 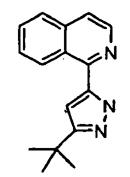 | 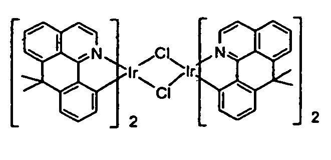 | 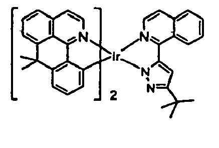 | 79.8 |
| 5s) | 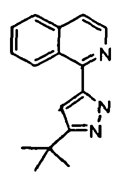 | 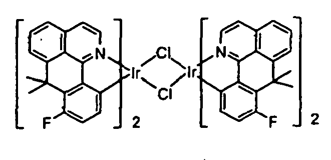 | 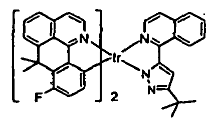 | 82.9 |

## Patentansprüche

1. Verfahren zur Herstellung von Metallkomplexen der Formel (1) 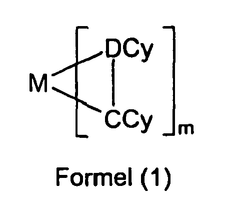 worin gilt:
M ist Rh, Ir, Pd oder Pt;
DCy ist bei jedem Auftreten gleich oder verschieden eine cyclische Gruppe, die mindestens ein neutrales Donoratom enthält, über welches die cyclische Gruppe an das Metall gebunden ist, und die einen oder mehrere Substituenten R tragen kann; die Gruppen DCy und CCy sind über eine kovalente Bindung miteinander verbunden; außerdem können sie weiterhin über einen Rest R miteinander verbunden sein;
CCy ist bei jedem Auftreten gleich oder verschieden eine cyclische Gruppe, die ein Kohlenstoffatom oder ein negativ geladenes Stickstoffatom enthält, über welches die cyclische Gruppe an das Metall gebunden ist, und die einen oder mehrere Substituenten R tragen kann;
R ist bei jedem Auftreten gleich oder verschieden F, Cl, Br, I, NO₂, CN, NH₂, NHR¹, N(R¹)₂, B(OH)₂, B(OR¹)₂, CHO, COOH, CONH₂, CON(R¹)₂, SO₃H, C(=O)R¹, P(=O)(R¹)₂, S(=O)R¹, S(=O)₂R¹, P(R¹)₃⁺, N(R¹)₃⁺, OH, SH, eine gerad- kettige Alkyl- oder Alkoxygruppe mit 1 bis 20 C-Atomen oder eine verzweigte oder cyclische Alkyl- oder Alkoxygruppe mit 3 bis 20 C-Atomen, wobei jeweils ein oder mehrere nicht benachbarte CH₂-Gruppen durch -O-, -S-, -NR¹-, -CONR¹-, -CO-O-, -CR¹=CR¹- oder -C≡C- ersetzt sein können und die auch durch eine oder mehrere Gruppen R² substituiert sein kann,
oder ein aromatisches oder heteroaromatisches Ringsystem mit 5 bis 30 aromatischen Ringatomen, das durch einen oder mehrere Reste R² substituiert sein kann,
oder eine Aryloxy-, Heteroaryloxy-, Arylamino- oder Hetero- arylaminogruppe mit 5 bis 30 aromatischen Ringatomen, die durch einen oder mehrere Reste R² substituiert sein kann; dabei können zwei oder mehrere Substituenten R, sowohl am selben Ring als auch an den beiden unterschiedlichen Ringen zusammen, wiederum miteinander oder mit R¹, R² und/oder R³ ein weiteres mono- oder polycyclisches, aliphatisches oder aromatisches Ringsystem aufspannen;
R¹ ist bei jedem Auftreten gleich oder verschieden H, eine geradkettige Alkylgruppe mit 1 bis 20 C-Atomen oder eine verzweigte oder cyclische Alkylgruppe mit 3 bis 20 C- Atomen, wobei jeweils ein oder mehrere nicht benachbarte CH₂-Gruppen, die nicht direkt an ein Heteroatom binden, durch -O-, -S-, -NR³-, -CONR³-, -CO-O-, -CR³=CR³- oder -C≡C- ersetzt sein können und die auch durch eine oder mehrere Gruppen R² substituiert sein kann, oder ein aromatisches oder heteroaromatisches Ringsystem mit 5 bis 30 aromatischen Ringatomen, das durch einen oder mehrere Reste R³ substituiert sein kann; dabei können zwei oder mehrere Substituenten R¹ wiederum miteinander oder mit R, R² und/oder R³ ein weiteres mono- oder polycyclisches, aliphatisches oder aromatisches Ringsystem aufspannen;
R² ist bei jedem Auftreten gleich oder verschieden H, F, Cl, Br, I, NO₂, CN, NH₂, NHR³, N(R³)₂, B(OH)₂, B(OR³)₂, CHO, COOH, CON(R³)₂, SO₃H, C(=O)R¹, P(=O)(R¹)₂, S(=O)R¹, S(=O)₂R¹, P(R³)₃⁺, N(R³)₃⁺, OH, SH, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, wobei jeweils ein oder mehrere nicht benachbarte CH₂-Gruppen durch -O-, -S-, -NR³-, -CONR³-, -CO-O-, -CR³=CR³- oder -C≡C- ersetzt sein können und die auch durch eine oder mehrere Gruppen R³ substituiert sein kann,
oder ein aromatisches oder heteroaromatisches Ringsystem mit 5 bis 30 aromatischen Ringatomen, das durch einen oder mehrere Reste R³ substituiert sein kann, oder eine Aryloxy-, Heteroaryloxy-, Arylamino- oder Heteroarylaminogruppe mit 5 bis 30 aromatischen Ringatomen, die durch einen oder mehrere Reste R³ substituiert sein kann; dabei können zwei oder mehrere Substituenten R², sowohl am selben Ring als auch an den beiden unterschiedlichen Ringen zusammen, wiederum miteinander oder mit R, R¹ und/oder R³ ein weiteres mono- oder polycyclisches, aliphatisches oder aromatisches Ringsystem aufspannen;
R³ ist gleich oder verschieden bei jedem Auftreten H oder ein aliphatischer oder aromatischer Kohlenwasserstoffrest mit 1 bis 20 C-Atomen; dabei können auch zwei oder mehrere Reste R³ miteinander ein Ringsystem bilden;
m ist 2 für M = Pd oder Pt und ist 3 für M = Rh oder Ir;
durch Umsetzung einer Metallverbindung der Formel (2), der Formel (3) oder der Formel (4) 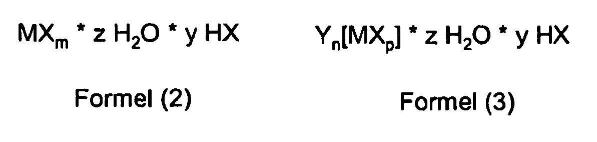 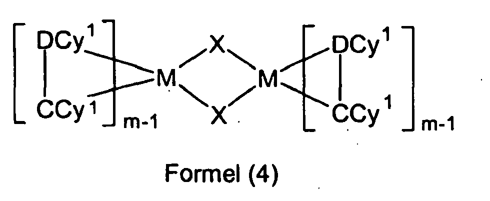 wobei M und m dieselbe Bedeutung haben, wie für Formel (1) beschrieben, und für die weiteren Symbole und Indizes gilt:
X ist bei jedem Auftreten gleich oder verschieden F, Cl, Br oder I;
Y ist bei jedem Auftreten gleich oder verschieden ein Alkali- metallkation, ein Erdalkalimetallkation, ein Ammoniumkation, ein Tetraalkylammoniumkation mit 4 bis 40 C-Atomen oder ein Tetraalkylphosphoniumkation mit 4 bis 40 C-Atomen;
p ist 4 für M = Pd oder Pt und ist 6 für M = Rh oder Ir;
n entspricht der Ladung von M für ein einwertiges Kation Y und entspricht der halben Ladung von M für ein zweiwertiges Kation Y;
z ist 0 bis 100;
y ist 0 bis 100;
mit einer Verbindung der Formel (5), 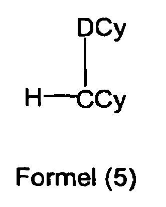 worin DCy und CCy die unter Formel (1) genannten Bedeutungen haben,
**dadurch gekennzeichnet, dass** die Reaktion in Anwesenheit eines Salzes, dessen Anion mindestens zwei Sauerstoffatome enthält, in einem Lösemittelgemisch aus mindestens einem organischen Lösemittel und mindestens 2 Vol.-% Wasser durchgeführt wird.

2. Verfahren nach Anspruch 1, **dadurch gekennzeichnet, dass** als Ausgangsverbindung eine Verbindung gemäß Formel (2) bzw. eine Verbindung gemäß Formel (3) mit einer Verbindung gemäß Formel (5) umgesetzt wird zu einem homoleptischen Metallkomplex oder dass eine Verbindung gemäß Formel (4) mit einem gleichartigen Liganden gemäß Formel (5) umgesetzt wird zu einem homoleptischen Metallkomplex oder dass eine Verbindung gemäß Formel (4) mit einem andersartigen Liganden gemäß Formel (5) umgesetzt wird zu einem heteroleptischen Metallkomplex.

3. Verfahren nach Anspruch 1 oder 2, **dadurch gekennzeichnet, dass** in Verbindungen gemäß Formel (2) der Index z für 1 bis 10 steht und der Index y für 0 bis 10 steht und dass in Verbindungen gemäß Formel (3) der Index z für 0 bis 10 und der Index y für 0 bis 10 steht.

4. Verfahren nach einem oder mehreren der Ansprüche 1 bis 3, **dadurch gekennzeichnet, dass** in den Metalledukten der Formeln (2), (3) und (4) das Symbol X, gleich oder verschieden bei jedem Auftreten, für Chlor oder Brom, bevorzugt für Chlor steht.

5. Verfahren nach einem oder mehreren der Ansprüche 1 bis 4, **dadurch gekennzeichnet, dass** das Symbol CCy, gleich oder verschieden bei jedem Auftreten, für eine aromatische oder heteroaromatische Gruppe mit 5 bis 20 aromatischen Ringatomen steht, welche einen oder mehrere Substituenten R tragen kann und welche über ein Kohlenstoffatom an das Metall bindet, und dass das Symbole DCy, gleich oder verschieden bei jedem Auftreten, für eine cyclische Gruppe mit 5 bis 20 Ringatomen steht, welche ein neutrales Stickstoffatom als Donoratom enthält, wobei der Stickstoff in einer Imin-Funktionalität gebunden oder Teil eines heteroaromatischen Systems ist.

6. Verfahren nach einem oder mehreren der Ansprüche 1 bis 5, **dadurch gekennzeichnet, dass** das zugesetzte Salz ein organisches oder ein anorganisches Salz oder eine zwitterionische Verbindung ist.

7. Verfahren nach einem oder mehreren der Ansprüche 1 bis 6, **dadurch gekennzeichnet, dass** die Sauerstoffatome in einer 1,3-, in einer 1,4- oder in einer 1,5-Anordnung in dem Salz gebunden sind.

8. Verfahren nach einem oder mehreren der Ansprüche 1 bis 7, **dadurch gekennzeichnet, dass** als anorganisches Salz ein Alkali-, Erdalkali-, Ammonium-, Tetraalkylammonium-, Tetraalkylphosphonium- und/oder Tetraarylphosphoniumsalz von Carbonat, Hydrogencarbonat, Sulfat, Hydrogensulfat, Sulfit, Hydrogensulfit, Nitrat, Nitrit, Phosphat, Hydrogenphosphat, Dihydrogenphosphat oder Borat zugesetzt wird und/oder dass als organisches Salz ein Alkali-, Erdalkali-, Ammonium-, Tetraalkylammonium-, Tetraalkylphosphonium- und/oder Tetraarylphosphoniumsalz organischer Carbonsäuren mit 1 bis 20 C-Atomen, organischer Sulfonsäuren mit 1 bis 20 C-Atomen, sowie von α-Ketocarboxytaten. β-Ketoketonaten, β-Ketocarboxylaten, Salze von Brenzcatechin und Salicylsäure zugesetzt wird und/oder dass als inneres Salz Aminocarbonsäuren, insbesondere α-, β- oder γ-Aminocarbonsäuren, aromatische Aminocarbonsäuren, Polyaminocarbonsäuren, N-alkylierte Aminocarbonsäuren, wobei die Alkylgruppen 1 bis 10 C-Atome enthalten, Aminosulfonsäuren oder N-alkylierte Aminosulfonsäuren, wobei die Alkylgruppen 1 bis 10 C-Atome enthalten, zugesetzt werden oder dass Salze dieser Verbindungen, die durch Abstraktion eines oder mehrerer Protonen erhalten werden, verwendet werden.

9. Verfahren nach einem oder mehreren der Ansprüche 1 bis 8, **dadurch gekennzeichnet, dass** das molare Verhältnis von Metall zum zugesetzten Salz 1:1 bis 1:1000 beträgt.

10. Verfahren nach einem oder mehreren der Ansprüche 1 bis 9, **dadurch gekennzeichnet, dass** die Reaktion in homogener Lösung durchgeführt wird.

11. Verfahren nach einem oder mehreren der Ansprüche 1 bis 10, **dadurch gekennzeichnet, dass** als organisches Lösemittel ein polar protisches und/oder ein polar aprotisches Lösemittel eingesetzt wird.

12. Verfahren nach einem oder mehreren der Ansprüche 1 bis 11, **dadurch gekennzeichnet, dass** als organisches Lösemittel Alkohole, insbesondere Alkohole mit 1 bis 5 C-Atomen, Diole, Polyalkohole, Alkoxyalkohole, wassermischbare offenkettige oder cyclische Ether, DMSO, NMP und/oder DMF eingesetzt werden.

13. Verfahren nach einem oder mehreren der Ansprüche 1 bis 12, **dadurch gekennzeichnet, dass** der Anteil von Wasser im Reaktionsmedium im Bereich von 5 bis 90 Vol.-% liegt.

14. Verfahren nach einem oder mehreren der Ansprüche 1 bis 13, **dadurch gekennzeichnet, dass** die Konzentration der Metallausgangsverbindung gemäß Formel (2) bzw. Formel (3) im Bereich von 0.5 mmol/l bis 100 mmol/l liegt und die Konzentration der Metall-Ausgangsverbindung gemäß Formel (4) im Bereich von 1 bis 1000 mmol/l liegt.

15. Verfahren nach einem oder mehreren der Ansprüche 1 bis 14, **dadurch gekennzeichnet, dass** das molare Verhältnis der Iridium-Verbindung gemäß Formel (2) bzw. Formel (3) zum Liganden gemäß Formel (5) 1:1 bis 1:60 beträgt und das molare Verhältnis der Iridium-Verbindung gemäß Formel (4) zum Liganden gemäß Formel (5) 1:1 bis 1:100 beträgt.

16. Verfahren zur Herstellung eines facialen tris-ortho-metallierten Metallkomplexes gemäß Formel (1), **dadurch gekennzeichnet, dass** ein Verfahren nach einem oder mehreren der Ansprüche 1 bis 15 zur Herstellung eines meridionalen Komplexes durchgeführt wird, gefolgt von einem Reaktionsschritt zur Überführung des meridionalen in das faciale Isomer des Komplexes.

17. Verwendung der Verfahrens nach einem oder mehreren der Ansprüche 1 bis 16 zur Herstellung von difunktionalisierten Verbindungen, wobei die funktionelle Gruppe der difunktionalisierten Verbindung ausgewählt ist aus Halogen, insbesondere Brom, Boronsäure oder Boronsäurederivaten, insbesondere Boronsäureestern.

## Claims

1. Process for the preparation of metal complexes of the formula (1), 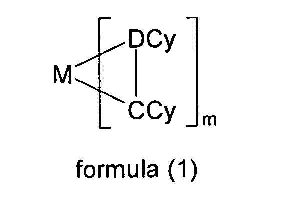 in which:
M is Rh, Ir, Pd or Pt;
DCy is on each occurrence, identically or differently, a cyclic group which contains at least one neutral donor atom via which the cyclic group is bonded to the metal and which may carry one or more substituents R; the groups DCy and CCy are connected to one another via a co- valent bond; in addition, they may furthermore be con- nected to one another via a radical R;
CCy is on each occurrence, identically or differently, a cyclic group which contains a carbon atom or a negatively charged nitrogen atom via which the cyclic group is bonded to the metal and which may carry one or more substituents R;
R is on each occurrence, identically or differently, F, Cl, Br, I, NO₂, CN, NH₂, NHR¹, N(R¹)₂, B(OH)₂, B(OR¹)₂, CHO, COOH, CONH₂, CON(R¹)₂, SO₃H, C(=O)R¹, P(=O)(R¹)₂, S(=O)R¹, S(=O)₂R¹, P(R¹)₃⁺, N(R¹)₃⁺, OH, SH, a straight-chain alkyl or alkoxy group having 1 to 20 C atoms or a branched or cyclic alkyl or alkoxy group having 3 to 20 C atoms, in each of which one or more non-adjacent CH₂ groups may be replaced by -O-, -S-, -NR¹-, -CONR¹-, -CO-O-, -CR¹=CR¹- or -C≡C- and which may also be substituted by one or more groups R²,
or an aromatic or heteroaromatic ring system having 5 to 30 aromatic ring atoms, which may be substituted by one or more radicals R²,
or an aryloxy, heteroaryloxy, arylamino or heteroaryl- amino group having 5 to 30 aromatic ring atoms, which may be substituted by one or more radicals R²; two or more substituents R here, both on the same ring and also on the two different rings together, may in turn define a further mono- or polycyclic, aliphatic or aroma- tic ring system with one another or with R¹, R² and/or R³;
R¹ is on each occurrence, identically or differently, H, a straight-chain alkyl group having 1 to 20 C atoms or a branched or cyclic alkyl group having 3 to 20 C atoms, in each of which one or more non-adjacent CH₂ groups which are not bonded directly to a heteroatom may be replaced by -O-, -S-, -NR³-, -CONR³-, -CO-O-, -CR³=CR³- or -C=C- and which may also be substituted by one or more groups R²,
or an aromatic or heteroaromatic ring system having 5 to 30 aromatic ring atoms, which may be substituted by one or more radicals R³; two or more substituents R¹ here may in turn define a further mono- or polycyclic, aliphatic or aromatic ring system with one another or with R, R² and/or R³;
R² is on each occurrence, identically or differently, H, F, Cl, Br, I, NO₂, CN, NH₂, NHR³, N(R³)₂, B(OH)₂, B(OR³)₂, CHO, COOH, CON(R³)₂, SO₃H, C(=O)R¹, P(=O)(R¹)₂, S(=O)R¹, S(=O)₂R¹, P(R³)₃+, N(R³)₃⁺, OH, SH, a straight-chain alkyl or alkoxy group having 1 to 20 C atoms or a branched or cyclic alkyl or alkoxy group having 3 to 20 C atoms, in each of which one or more non-adjacent CH₂ groups may be replaced by -O-, -S-, -NR³-, -CONR³-, -CO-O-, -CR³=CR³- or -C=C- and which may also be substituted by one or more groups R³,
or an aromatic or heteroaromatic ring system having 5 to 30 aromatic ring atoms, which may be substituted by one or more radicals R³, or an aryloxy, heteroaryloxy, arylamino or heteroarylamino group having 5 to 30 aromatic ring atoms, which may be substituted by one or more radicals R³; two or more substituents R² here, both on the same ring and also on the two different rings together, may in turn define a further mono- or polycyclic, aliphatic or aromatic ring system with one another or with R, R¹ and/or R³;
R³ is, identically or differently on each occurrence, H or an aliphatic or aromatic hydrocarbon radical having 1 to 20 C atoms; two or more radicals R³ here may also form a ring system with one another;
m is 2 for M = Pd or Pt and is 3 for M = Rh or Ir;
by reaction of a metal compound of the formula (2), of the formula (3) or of the formula (4), 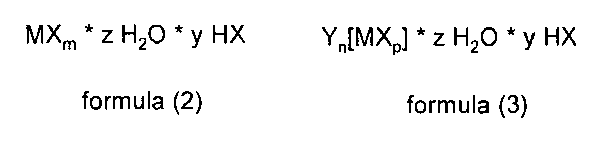 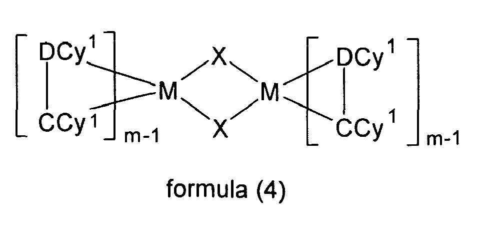 where M and m have the same meaning as described for formula (1), and the following applies to the other symbols and indices:
X is on each occurrence, identically or differently, F, Cl, Br or I;
Y is on each occurrence, identically or differently, an alkali metal cation, an alkaline-earth metal cation, an ammo- nium cation, a tetraalkylammonium cation having 4 to 40 C atoms or a tetraalkylphosphonium cation having 4 to 40 C atoms;
p is 4 for M = Pd or Pt and is 6 for M = Rh or Ir;
n corresponds to the charge of M for a monovalent cation Y and corresponds to half the charge of M for a divalent cation Y;
z is 0 to 100;
y is 0 to 100;
with a compound of the formula (5), 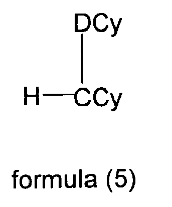 in which DCy and CCy have the meanings mentioned under formula (1),
**characterised in that** the reaction is carried out in the presence of a salt whose anion contains at least two oxygen atoms, in a solvent mixture comprising at least one organic solvent and at least 2% by vol. of water.

2. Process according to Claim 1, **characterised in that**, as starting compound, a compound of the formula (2) or a compound of the formula (3) is reacted with a compound of the formula (5) to give a homoleptic metal complex or **in that** a compound of the formula (4) is reacted with a ligand of the formula (5) of the same type to give a homoleptic metal complex or **in that** a compound of the formula (4) is reacted with a ligand of the formula (5) of a different type to give a heteroleptic metal complex.

3. Process according to Claim 1 or 2, **characterised in that**, in compounds of the formula (2), the index z stands for 1 to 10 and the index y stands for 0 to 10, and **in that**, in compounds of the formula (3), the index z stands for 0 to 10 and the index y stands for 0 to 10.

4. Process according to one or more of Claims 1 to 3, **characterised in that**, in the metal starting materials of the formulae (2), (3) and (4), the symbol X stands, identically or differently on each occurrence, for chlorine or bromine, preferably chlorine.

5. Process according to one or more of Claims 1 to 4, **characterised in that** the symbol CCy stands, identically or differently on each occurrence, for an aromatic or heteroaromatic group having 5 to 20 aromatic ring atoms which may carry one or more substituents R and which is bonded to the metal via a carbon atom, and **in that** the symbol DCy stands, identically or differently on each occurrence, for a cyclic group having 5 to 20 ring atoms which contains a neutral nitrogen atom as donor atom, where the nitrogen is bonded in an imine functionality or is part of a heteroaromatic system.

6. Process according to one or more of Claims 1 to 5, **characterised in that** the added salt is an organic salt or an inorganic salt or a zwitterionic compound.

7. Process according to one or more of Claims 1 to 6, **characterised in that** the oxygen atoms are bonded in the salt in a 1,3-, 1,4- or 1,5-arrangement.

8. Process according to one or more of Claims 1 to 7, **characterised in that** the inorganic salt added is an alkali metal, alkaline-earth metal, ammonium, tetraalkylammonium, tetraalkylphosphonium and/or tetraarylphosphonium salt of carbonate, hydrogencarbonate, sulfate, hydrogensulfate, sulfite, hydrogensulfite, nitrate, nitrite, phosphate, hydrogenphosphate, dihydrogenphosphate or borate, and/or **in that** the organic salt added is an alkali metal, alkaline-earth metal, ammonium, tetraalkylammonium, tetraalkylphosphonium and/or tetraarylphosphonium salt of organic carboxylic acids having 1 to 20 C atoms, of organic sulfonic acids having 1 to 20 C atoms, and of α-ketocarboxylates, β-ketoketonates, β-ketocarboxylates, salts of pyrocatechol and salicylic acid, and/or **in that** the internal salt added is an aminocarboxylic acid, in particular an α-, β- or γ-aminocarboxylic acid, an aromatic aminocarboxylic acid, polyaminocarboxylic acid, N-alkylated aminocarboxylic acid, where the alkyl groups contain 1 to 10 C atoms, aminosulfonic acid or N-alkylated aminosulfonic acid, where the alkyl groups contain 1 to 10 C atoms, or **in that** salts of these compounds which are obtained by abstraction of one or more protons are used.

9. Process according to one or more of Claims 1 to 8, **characterised in that** the molar ratio of metal to the added salt is 1:1 to 1:1000.

10. Process according to one or more of Claims 1 to 9, **characterised in that** the reaction is carried out in homogeneous solution.

11. Process according to one or more of Claims 1 to 10, **characterised in that** the organic solvent employed is a polar protic and/or polar aprotic solvent.

12. Process according to one or more of Claims 1 to 11, **characterised in that** the organic solvent employed is an alcohol, in particular an alcohol having 1 to 5 C atoms, a diol, polyalcohol, alkoxyalcohol, watermiscible open-chain or cyclic ether, DMSO, NMP and/or DMF.

13. Process according to one or more of Claims 1 to 12, **characterised in that** the proportion of water in the reaction medium is in the range from 5 to 90% by vol.

14. Process according to one or more of Claims 1 to 13, **characterised in that** the concentration of the metal starting compound of the formula (2) or formula (3) is in the range from 0.5 mmol/I to 100 mmol/l, and the concentration of the metal starting compound of the formula (4) is in the range from 1 to 1000 mmol/l.

15. Process according to one or more of Claims 1 to 14, **characterised in that** the molar ratio of the iridium compound of the formula (2) or formula (3) to the ligand of the formula (5) is 1:1 to 1:60, and the molar ratio of the iridium compound of the formula (4) to the ligand of the formula (5) is 1:1 to 1:100.

16. Process for the preparation of a facial tris-ortho-metallated metal complex of the formula (1), **characterised in that** a process according to one or more of Claims 1 to 15 for the preparation of a meridional complex is carried out, followed by a reaction step for conversion of the meridional isomer into the facial isomer of the complex.

17. Use of the process according to one or more of Claims 1 to 16 for the preparation of difunctionalised compounds, where the functional group of the difunctionalised compound is selected from halogen, in particular bromine, boronic acid or boronic acid derivatives, in particular boronic acid esters.

## Revendications

1. Procédé pour la préparation de complexes métalliques de la formule (1), 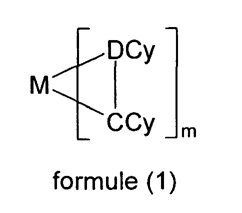 dans laquelle :
M est Rh, Ir, Pd ou Pt ;
DCy est, pour chaque occurrence, de manière identique ou différente, un groupe cyclique qui contient au moins un atome de donneur neutre via lequel le groupe cyclique est lié au métal et qui peut être porteur d'un ou plu- sieurs substituants R ; les groupes DCy et CCy sont connectés l'un à l'autre via une liaison covalente ; en outre, ils peuvent être encore connectés l'un à l'autre via un radical R ;
CCy est, pour chaque occurrence, de manière identique ou différente, un groupe cyclique qui contient un atome de carbone ou un atome d'azote chargé négativement via lequel le groupe cyclique est lié au métal et qui peut être porteur d'un ou plusieurs substituants R ;
R est, pour chaque occurrence, de manière identique ou différente, F, CI, Br, I, NO₂, CN, NH₂, NHR¹, N(R¹)₂, B(OH)₂, B(OR¹)₂, CHO, COOH, CONH₂, CON(R¹)₂, SO₃H, C(=O)R¹, P(=O)(R¹)₂, S(=O)R¹, S(=O)₂R¹, P(R¹)₃⁺, N(R¹)₃⁺, OH, SH, un groupe alkyle ou alcoxy en chaîne droite comportant 1 à 20 atomes de C ou un groupe alkyle ou alcoxy ramifié ou cyclique comportant 3 à 20 atomes de C, et au niveau de chacun, un ou plusieurs groupes CH₂ non adjacents peuvent être remplacés par -O-, -S-, -NR¹-, -CONR¹-, -CO-O-, -CR¹=CR¹- ou -C≡C- et qui peut également être subs- titué par un ou plusieurs groupes R²,
ou un système de cycle aromatique ou hétéroaroma- tique comportant 5 à 30 atomes de cycle aromatique, qui peut être substitué par un ou plusieurs radicaux R², ou un groupe aryloxy, hétéroaryloxy, arylamino ou hété- roarylamino comportant 5 à 30 atomes de cycle aroma- tique, qui peut être substitué par un ou plusieurs radi- caux R² ; deux ou plusieurs substituants R ici, à la fois sur le même cycle et également sur les deux cycles différents ensemble, peuvent à leur tour définir un autre système de cycle aliphatique ou aromatique, mono- ou polycyclique les uns avec les autres ou avec R¹, R² et/ou R³ ;
R¹ est, pour chaque occurrence, de manière identique ou différente, H, un groupe alkyle en chaîne droite com- portant 1 à 20 atomes de C ou un groupe alkyle ramifié ou cyclique comportant 3 à 20 atomes de C, au niveau de chacun, un ou plusieurs groupes CH₂ non adjacents qui ne sont pas liés directement à un hétéroatome peu- vent être remplacés par -O-, -S-, -NR³-, -CONR³-, -CO-O-, -CR³=CR3- ou -C≡C- et qui peut également être substitué par un ou plusieurs groupes R², ou un système de cycle aromatique ou hétéroaroma- tique comportant 5 à 30 atomes de cycle aromatique, qui peut être substitué par un ou plusieurs radicaux R³ ; deux ou plusieurs substituants R¹ ici peuvent à leur tour définir un autre système de cycle aliphatique ou aroma- tique, mono- ou polycyclique les uns avec les autres ou avec R¹, R² et/ou R^{3 ;}
R² est, pour chaque occurrence, de manière identique ou différente, H, F, CI, Br, I, NO₂, CN, NH₂, NHR³, N(R³)₂, B(OH)₂, B(OR³)₂, CHO, COOH, CON(R³)₂, SO₃H, C(=O)R¹, P(=O)(R¹)₂, S(=O)R¹, S(=O)₂R¹, P(R³)₃⁺, N(R³)₃⁺, OH, SH, un groupe alkyle ou alcoxy en chaîne droite comportant 1 à 20 atomes de C ou un groupe alkyle ou alcoxy ramifié ou cyclique comportant 3 à 20 atomes de C, au niveau de chacun, un ou plusieurs groupes CH₂ non adjacents peuvent être remplacés par -O-, -S-, -NR³-, -CONR³-, -CO-O-, -CR³=CR³- ou -C=C- et qui peut également être substitué par un ou plusieurs groupes R³,
ou un système de cycle aromatique ou hétéroaroma- tique comportant 5 à 30 atomes de cycle aromatique, qui peut être substitué par un ou plusieurs radicaux R³, ou un groupe aryloxy, hétéroaryloxy, arylamino ou hété- roarylamino comportant 5 à 30 atomes de cycle aroma- tique, qui peut être substitué par un ou plusieurs groupes R³ ; deux ou plusieurs substituants R² ici, à la fois sur le même cycle et également sur les deux cycles différents ensemble, peuvent à leur tour définir un autre système de cycle aliphatique ou aromatique, mono- ou polycyclique les uns avec les autres ou avec R, R¹ et/ou R³ ;
R³ est, de manière identique ou différente, H ou un radical hydrocarbone aliphatique ou aromatique comportant 1 à 20 atomes de C ; deux radicaux R³ ou plus ici peu- vent également former un système de cycle les uns avec les autres ;
m est 2 pour M = Pd ou Pt et est 3 pour M = Rh ou Ir ;
par réaction d'un composé métallique de la formule (2), de la formule (3) ou de la formule (4), 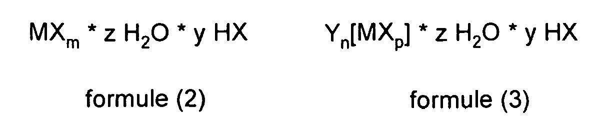 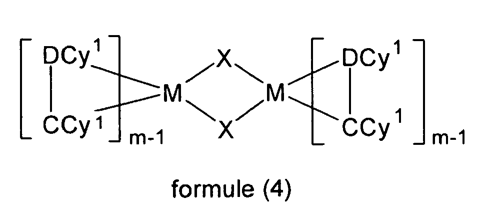 dans lesquelles M et m présentent la même signification que décrit pour la formule (1), et ce qui suit s'applique aux autres symboles et indices :
X est, pour chaque occurrence, de manière identique ou différente, F, CI, Br ou I;
Y est, pour chaque occurrence, de manière identique ou différente, un cation de métal alcalin, un cation de métal alcalino-terreux, un cation d'ammonium, un cation de tétraalkylammonium comportant 4 à 40 atomes de C ou un cation de tétraalkylphosphonium comportant 4 à 40 atomes de C ;
p est 4 pour M = Pd ou Pt et est 6 pour M = Rh ou Ir ;
n correspond à la charge de M pour un cation mono- valent Y et correspond à la moitié de la charge de M pour un cation divalent Y ;
z est 0 à 100;
y est 0 à 100;
avec un composé de la formule (5), 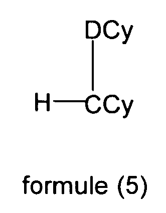 dans laquelle DCy et CCy présentent les significations mentionnées sous la formule (1),
**caractérisé en ce que** la réaction est mise en oeuvre en présence d'un sel dont l'anion contient au moins deux atomes d'oxygène, dans un mélange de solvant comprenant au moins un solvant organique et au moins 2% en vol. d'eau.

2. Procédé selon la revendication 1, **caractérisé en ce que**, en tant que composé de départ, un composé de la formule (2) ou un composé de la formule (3) est amené à réagir avec un composé de la formule (5) pour obtenir un complexe métallique homoleptique ou **en ce qu'**un composé de la formule (4) est amené à réagir avec un ligand de la formule (5) du même type pour obtenir un complexe métallique homoleptique ou **en ce qu'**un composé de la formule (4) est amené à réagir avec un ligand de la formule (5) d'un type différent pour obtenir un complexe métallique hétéroleptique.

3. Procédé selon la revendication 1 ou 2, **caractérisé en ce que**, dans les composés de la formule (2), l'indice z représente 1 à 10 et l'indice y représente 0 à 10, et **en ce que**, dans les composés de la formule (3), l'indice z représente 0 à 10 et l'indice y représente 0 à 10.

4. Procédé selon une ou plusieurs des revendications 1 à 3, **caractérisé en ce que**, dans les matériaux de départ métalliques des formules (2), (3) et (4), le symbole X représente, de manière identique ou différente pour chaque occurrence, chlore ou brome, de préférence chlore.

5. Procédé selon une ou plusieurs des revendications 1 à 4, **caractérisé en ce que** le symbole CCy représente, de manière identique ou différente pour chaque occurrence, un groupe aromatique ou hétéroaromatique comportant 5 à 20 atomes de cycle aromatique qui peut être porteur d'un ou de plusieurs substituants R et qui est lié au métal via un atome de carbone, et **en ce que** le symbole DCy représente, de manière identique ou différente pour chaque occurrence, un groupe cyclique comportant 5 à 20 atomes de cycle qui contient un atome d'azote neutre en tant qu'atome de donneur, où l'azote est lié dans une fonctionnalité imine ou est une partie d'un système hétéroaromatique.

6. Procédé selon une ou plusieurs des revendications 1 à 5, **caractérisé en ce que** le sel ajouté est un sel organique ou un sel inorganique ou un composé zwitterionique.

7. Procédé selon une ou plusieurs des revendications 1 à 6, **caractérisé en ce que** les atomes d'oxygène sont liés dans le sel selon un agencement 1,3-, 1,4- ou 1,5.

8. Procédé selon une ou plusieurs des revendications 1 à 7, **caractérisé en ce que** le sel inorganique ajouté est un sel de métal alcalin, un sel de métal alcalino-terreux, un sel d'ammonium, un sel de tétraalkylammonium, un sel de tétraalkylphosphonium et/ou un sel de tétraarylphosphonium de carbonate, hydrogencarbonate, sulfate, hydrogènesulfate, sulfite, hydrogènesulfite, nitrate, nitrite, phosphate, hydrogènephosphate, dihydrogènephosphate ou borate, et/ou **en ce que** le sel organique ajouté est un sel de métal alcalin, un sel de métal alcalino-terreux, un sel d'ammonium, un sel de tétraalkylammonium, un sel de tétraalkylphosphonium et/ou un sel de tétraarylphosphonium d'acides carboxyliques organiques comportant 1 à 20 atomes de C, d'acides sulfoniques organiques comportant 1 à 20 atomes de C, et de α-cétocarboxylates, β-cétocétonates, β-cétocarboxylates, sels d'acide pyrocatéchol et salicylique, et/ou **en ce que** le sel interne ajouté est un acide aminocarboxylique, en particulier un acide α-, β- ou γ-aminocarboxylique, un acide aminocarboxylique aromatique, un acide polyaminocarboxylique, un acide aminocarboxylique N-alkylaté, où les groupes alkyle contiennent 1 à 10 atomes de C, un acide aminosulfonique ou un acide aminosulfonique N-alkylaté, où les groupes alkyle contiennent 1 à 10 atomes de C, ou en ce que des sels de ces composés qui sont obtenus par abstraction d'un ou plusieurs protons sont utilisés.

9. Procédé selon une ou plusieurs des revendications 1 à 8, **caractérisé en ce que** le rapport molaire du métal sur le sel ajouté est de 1:1 à 1:1000.

10. Procédé selon une ou plusieurs des revendications 1 à 9, **caractérisé en ce que** la réaction est mise en oeuvre dans une solution homogène.

11. Procédé selon une ou plusieurs des revendications 1 à 10, **caractérisé en ce que** le solvant organique utilisé est un solvant protique polaire et/ou aprotique polaire.

12. Procédé selon une ou plusieurs des revendications 1 à 11, **caractérisé en ce que** le solvant organique utilisé est un alcool, en particulier un alcool comportant 1 à 5 atomes de C, un diol, un polyalcool, un alcoxyalcool, un éther cyclique ou en chaîne ouverte miscible dans l'eau, DMSO, NMP et/ou DMF.

13. Procédé selon une ou plusieurs des revendications 1 à 12, **caractérisé en ce que** la proportion d'eau dans le milieu de réaction est dans la plage de 5 à 90% en vol.

14. Procédé selon une ou plusieurs des revendications 1 à 13, **caractérisé en ce que** la concentration du composé de départ métallique de la formule (2) ou de la formule (3) est dans la plage de 0,5 mmol/l à 100 mmol/l, et la concentration du composé de départ métallique de la formule (4) est dans la plage de 1 à 1000 mmol/l.

15. Procédé selon une ou plusieurs des revendications 1 à 14, **caractérisé en ce que** le rapport molaire du composé iridium de la formule (2) ou de la formule (3) sur le ligand de la formule (5) est de 1:1 à 1:60, et le rapport molaire du composé iridium de la formule (4) sur le ligand de la formule (5) est de 1:1 à 1:100.

16. Procédé pour la préparation d'un complexe métallique tris-orthométallaté facial de la formule (1), **caractérisé en ce qu'**un procédé selon une ou plusieurs des revendications 1 à 15 pour la préparation d'un complexe méridional est mis en oeuvre, suivi par une étape de réaction pour la conversion de l'isomère méridional selon l'isomère facial du complexe.

17. Utilisation du procédé selon une ou plusieurs des revendications 1 à 16 pour la préparation de composés difonctionnalisés, où le groupe fonctionnel du composé difonctionnalisé est choisi parmi halogène, en particulier brome, acide boronique ou dérivés d'acide boronique, en particulier esters d'acide boronique.
